# EUROPEAN PATENT APPLICATION

(11) **EP 4 339 640 A1**
(43) Date of publication of application: **20.03.2024**
(21) Application number: 23156001.2
(22) Date of filing: 10.02.2023
(51) Int. Cl.: G01S 7/4861, G01S 17/89, G01S 17/931

(54) **LIGHT DETECTOR, LIGHT DETECTION SYSTEM, AND LIDAR DEVICE**

(30) Priority: 16.09.2022 JP 2022148506
(71) Applicant: KABUSHIKI KAISHA TOSHIBA, Minato-ku Tokyo 105-0023 (JP)
(72) Inventor: SASAKI, Keita, Tokyo, 105-0023 (JP); SHIMIZU, Mariko, Toyko, 105-0023 (JP); SUZUKI, Kazuhiro, Tokyo, 105-0023 (JP)
(74) Representative: Hoffmann Eitle

(57) **Abstract**

A light detector (201) includes a light-receiving region (Rp) that includes multiple light-receiving elements (10), periodically arranged in a two-dimensional array, and a transistor region (Rt) in which an integrated circuit of a read circuit is located. Light-receiving element (10) includes trench (T1), photoelectric conversion part (17) surrounded with trench (T1), and quenching part (63). Photoelectric conversion part (17) and quenching part (63) are electrically connected in series via contact holes and first wiring layer (51). Trench (T2) is provided in the transistor region (Rt) to surround the region in which transistors are formed. Light detector (201) is provided in SOI (Silicon On Insulator) substrate (20) that includes first semiconductor layer (21) as a support substrate, second semiconductor layer (22) as an active layer, and insulating layer (23) as a BOX (buried oxide) layer. Trench (T2) is formed to extend to insulating layer (23) for element separation. Multilevel wiring part (70) is a stacked structure on a silicon substrate formed by metal wiring processes. Trench (T1) is formed to the lower region to which the depletion layer of the photoelectric conversion part (17) spreads; and the bottom portion of trench (T1) stops inside the second semiconductor layer (22) and does not extend to insulating layer (23). A portion of the incident light incident on the photoelectric conversion part (17) is reflected by trench (T1) at the interface between trench (T1) and photoelectric conversion part (17), so that the sensitivity of the light detector can be increased.

## Description

### FIELD

Embodiments relate to a light detector, a light detection system, and a lidar device.

### BACKGROUND

A lidar (LiDAR: Light Detection And Ranging) device is one sensing technology that can generate a 3D point cloud of the surrounding environment by using laser light to measure distances to objects. A lidar device is applied to the sensor system of a self-driving automobile or the like because distance information to the object is added to each pixel of the image that is imaged by the lidar device. The lidar device generally includes a light-projecting system that irradiates light and a light-receiving system that detects light reflected by the object; a laser of near-infrared light is used as the light source of the light-projecting system; and a sensor device that has a Geiger mode operation such as a SiPM (Silicon Photomultiplier), a SPAD (Single Photon Avalanche Diode), or the like is used as the light detector of the light-receiving system.

In many systems, there are expectations for further sensitivity improvements of the light detector because although it is desirable for lidar devices to detect accurate distance information of more distant objects, there are also future expectations for limiting the irradiated laser power for eye safety, improving the angle of view and resolution of 3D point clouds, downsizing the device, etc.

The spectral response of a SiPM is largely dependent on the absorption characteristics of silicon; and the sensitivity region in the depth direction of a general SiPM is much less than the absorption length of near-infrared light; therefore, the sensitivity is low because almost all of the incident light undergoes photoelectric conversion outside the sensitivity region and does not contribute to the sensitivity. Therefore, various measures for increasing sensitivity are being performed such as making the back surface of the silicon substrate into a scattering surface by making an unevenness by laser patterning technology, or making the back surface into a BSI structure by removal by dry etching, but the addition of complex processes may cause higher costs and lower yields in terms of patterning reproducibility.

### BRIEF DESCRIPTION OF THE DRAWINGS

FIG. 1 is a schematic plan view illustrating a light detector according to a first embodiment;
FIG. 2 is a schematic plan view illustrating a light detector according to the first embodiment;
FIG. 3 is a schematic cross-sectional view illustrating the light detector according to the first embodiment;
FIG. 4 is a schematic cross-sectional view illustrating a light detector according to the first embodiment;
FIG. 5 is a schematic cross-sectional view illustrating a light detector according to the first embodiment;
FIG. 6 is a schematic cross-sectional view illustrating a light detector according to the first embodiment;
FIGS. 7A and 7B are schematic views illustrating a simulation of the light detector;
FIG. 8 is a schematic cross-sectional view illustrating a light detector according to the first embodiment;
FIG. 9 is a schematic cross-sectional view illustrating a light detector according to the first embodiment;
FIG. 10 is a schematic cross-sectional view illustrating a light detector according to the first embodiment;
FIG. 11 is a schematic cross-sectional view illustrating a light detector according to the first embodiment;
FIG. 12 is a schematic cross-sectional view illustrating a light detector according to the first embodiment;
FIGS. 13A and 13B are schematic plan views illustrating a light detector according to the first embodiment;
FIGS. 14A and 14B are schematic plan views illustrating a light detector according to the first embodiment;
FIGS. 15A and 15B are schematic plan views illustrating a light detector according to the first embodiment;
FIGS. 16A and 16B are schematic plan views illustrating a light detector according to the first embodiment;
FIG. 17 is a schematic cross-sectional view illustrating a light detector according to the first embodiment;
FIGS. 18A and 18B are schematic plan views illustrating a light detector according to the first embodiment;
FIG. 19 is a schematic cross-sectional view illustrating a light detector according to the first embodiment;
FIG. 20 is a schematic cross-sectional view illustrating a light detector according to the first embodiment;
FIG. 21 is a schematic cross-sectional view in order of the processes, illustrating the method for manufacturing the light detector according to the first embodiment;
FIG. 22 is a schematic cross-sectional view in order of the processes, illustrating the method for manufacturing the light detector according to the first embodiment;
FIG. 23 is a schematic cross-sectional view in order of the processes, illustrating the method for manufacturing the light detector according to the first embodiment;
FIG. 24 is a schematic cross-sectional view in order of the processes, illustrating the method for manufacturing the light detector according to the first embodiment;
FIG. 25 is a schematic cross-sectional view in order of the processes, illustrating the method for manufacturing the light detector according to the first embodiment;
FIG. 26 is a schematic plan view illustrating a light detector according to a second embodiment;
FIG. 27 is a schematic plan view illustrating a light detector according to the second embodiment;
FIG. 28 is a schematic cross-sectional view illustrating the light detector according to the second embodiment;
FIG. 29 is a schematic cross-sectional view illustrating the light detector according to the second embodiment;
FIG. 30 is a schematic cross-sectional view illustrating the light detector according to the second embodiment;
FIG. 31 is a schematic cross-sectional view illustrating the light detector according to the second embodiment;
FIG. 32 is a schematic cross-sectional view illustrating the light detector according to the second embodiment;
FIG. 33 is a schematic cross-sectional view illustrating the light detector according to the second embodiment;
FIG. 34 is a schematic cross-sectional view in order of the processes, illustrating the method for manufacturing the light detector according to the second embodiment;
FIG. 35 is a schematic cross-sectional view in order of the processes, illustrating the method for manufacturing the light detector according to the second embodiment;
FIG. 36 is a schematic cross-sectional view in order of the processes, illustrating the method for manufacturing the light detector according to the second embodiment;
FIG. 37 is a schematic cross-sectional view in order of the processes, illustrating the method for manufacturing the light detector according to the second embodiment;
FIG. 38 is a schematic cross-sectional view in order of the processes, illustrating the method for manufacturing the light detector according to the second embodiment;
FIG. 39 is a schematic cross-sectional view illustrating a light detector according to the second embodiment;
FIG. 40 is a schematic cross-sectional view illustrating a light detector according to the second embodiment;
FIG. 41 is a schematic view illustrating an active quenching circuit;
FIG. 42 is a schematic view illustrating a lidar (Light Detection and Ranging (LiDAR)) device according to the embodiment;
FIG. 43 describes the detection of the detection object of the lidar device; and
FIG. 44 is a schematic top view of a mobile body that includes the lidar device according to the embodiment.

### DETAILED DESCRIPTION

A light detector according to one embodiment, includes a substrate. The substrate includes a first semiconductor layer, an insulating layer, and a second semiconductor layer. The insulating layer is located on the first semiconductor layer. The second semiconductor layer is located on the insulating layer. The second semiconductor layer includes a photoelectric conversion part. The photoelectric conversion part includes a first semiconductor region and a second semiconductor region. The first semiconductor region is of a first conductivity type. The second semiconductor region is of a second conductivity type. The substrate includes a void and a trench. The void is positioned below the photoelectric conversion part and between the first semiconductor layer and the second semiconductor layer. The trench surrounds the photoelectric conversion part. A lower end of the trench is positioned in the second semiconductor layer. The photoelectric conversion part is electrically connected with an upper surface side of the substrate via a portion below the trench.

A light detector according to one embodiment, includes a substrate. The substrate includes a first semiconductor layer, an insulating layer, and a second semiconductor layer. The insulating layer is located on the first semiconductor layer. The second semiconductor layer is located on the insulating layer. The substrate includes a light-receiving region, and a transistor region. The light-receiving region includes a photoelectric conversion part. The photoelectric conversion part includes a first semiconductor region and a second semiconductor region. The first semiconductor region is of a first conductivity type. The second semiconductor region is of a second conductivity type. A first trench is provided in the light-receiving region. The transistor region is arranged with the light-receiving region in a direction perpendicular to a first direction. The first direction is from the first semiconductor layer toward the second semiconductor layer. The transistor region includes a transistor. The transistor region includes a second trench located between the light-receiving region and at least a portion of the transistor. In the light-receiving region, the second semiconductor layer further includes a third semiconductor region and a fourth semiconductor region. The third semiconductor region is positioned above the insulating layer. The third semiconductor region is of the second conductivity type. The fourth semiconductor region is positioned above the third semiconductor region and electrically connected with the third semiconductor region. The fourth semiconductor region is of the second conductivity type. The first trench is positioned between the fourth semiconductor region and the photoelectric conversion part. A portion of the third semiconductor region is positioned below the first trench. The third semiconductor region electrically connects the photoelectric conversion part and the fourth semiconductor region.

Exemplary embodiments will now be described with reference to the drawings.

The drawings are schematic or conceptual; and the relationships between the thickness and width of portions, the proportional coefficients of sizes among portions, etc., are not necessarily the same as the actual values thereof. Furthermore, the dimensions and proportional coefficients may be illustrated differently among drawings, even for identical portions.

In the specification of the application and the drawings, components similar to those described in regard to a drawing thereinabove are marked with like reference numerals, and a detailed description is omitted as appropriate.

According to embodiments, a first conductivity type is one of a p-type or an n-type. A second conductivity type is the other of the p-type or the n-type. In the following description, the first conductivity type is the n-type, and the second conductivity type is the p-type.

### First embodiment

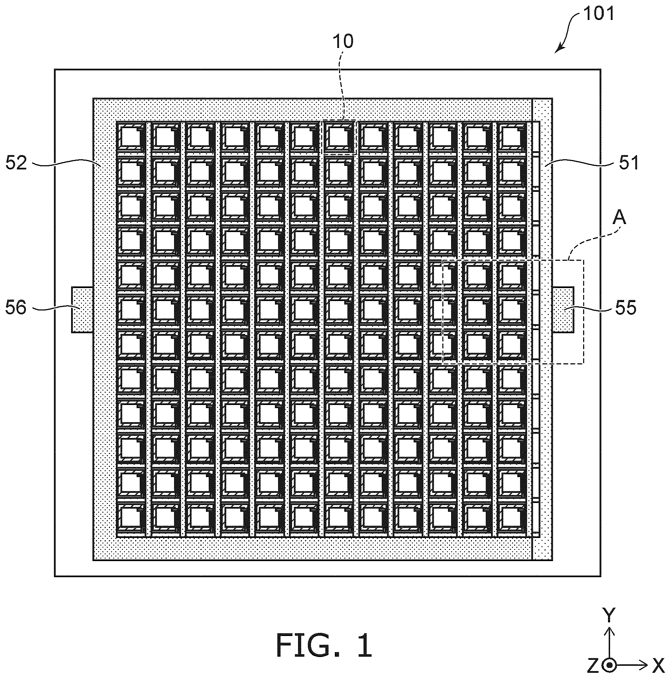

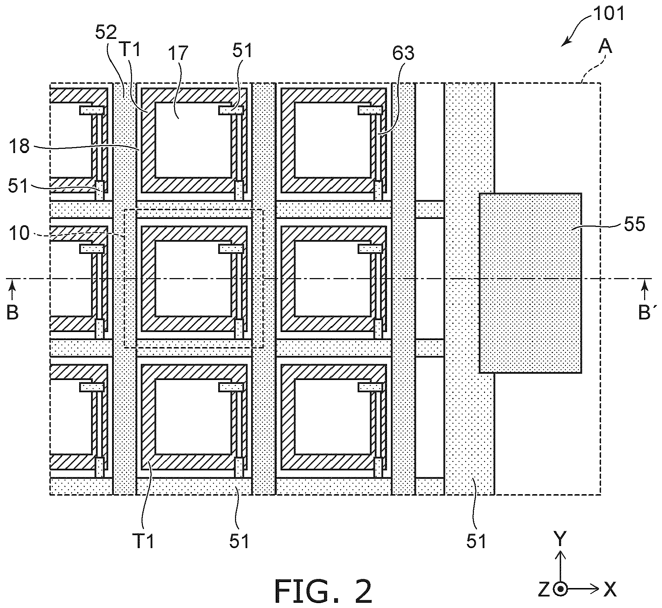

FIGS. 1 and 2 are schematic plan views illustrating a light detector according to a first embodiment.

FIG. 2 illustrates an enlarged region A illustrated in FIG. 1. As illustrated in FIGS. 1 and 2, the light detector 101 according to the embodiment includes one or more light-receiving elements 10. In the example as illustrated in FIG. 1, the light detector 101 includes multiple light-receiving elements 10, multiple first wiring layers 51, multiple second wiring layers 52, a first electrode pad 55, and a second electrode pad 56. As illustrated in FIG. 2, the light-receiving element 10 includes a trench T1 formed in a rectangular pattern, a photoelectric conversion part 17 surrounded with the trench T1, and a quenching part 63. Although not illustrated, the photoelectric conversion part 17 and the quenching part 63 are electrically connected in series via contact holes and the first wiring layer 51.

The quenching part 63 is connected to the first wiring layer 51 via the contact hole at a side not connected with the photoelectric conversion part 17. The light-receiving elements 10 that are periodically arranged in a two-dimensional array configuration are electrically connected in parallel by the first wiring layer 51, are electrically connected with the first electrode pad 55 via interlayer interconnects and the second wiring layer 52, and function as an anode or cathode electrode of the light detector by being connected with an external device.

On the other hand, in the light-receiving element 10, a bias region 18 in the peripheral part of the trench T1 is electrically connected with the second electrode pad 56 via contact holes, the first wiring layer 51, interlayer interconnects, and the second wiring layer 52 and functions as a cathode or anode electrode of the light detector 101 by being connected with the external device. The first electrode pad 55 and the second electrode pad 56 are different electrical signal systems that are electrically insulated from each other; and the voltages of the first and second electrode pads 55 and 56 that are applied from the outside are applied as a bias voltage to the photoelectric conversion part 17 and drive the light-receiving element 10. The first wiring layer 51 and the second wiring layer 52 are not limited to the layout shown in FIG. 2; and the wiring pattern of the first and second wiring layers 51 and 52 is changed as necessary to apply the anode potential and the cathode potential to the light-receiving element 10. To this end, although not illustrated, third and fourth wiring layers, etc., also may be used as necessary.

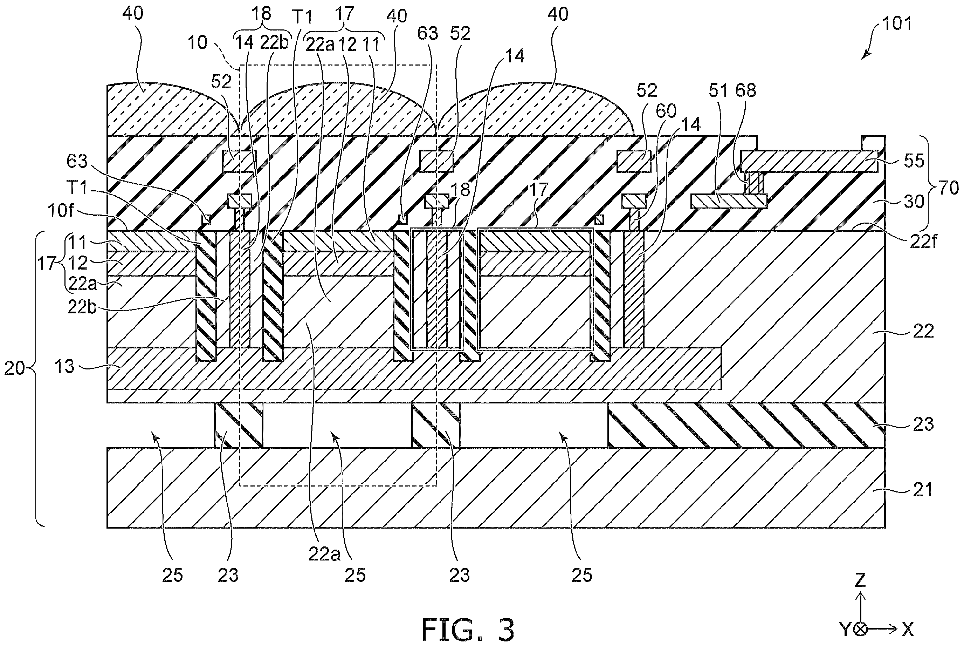

An example of a structure will now be described with reference to FIGS. 3 to 6. However, the following description related to FIGS. 3 to 6 is an example; and the light detector according to the embodiment is not limited to the description below.

In the description of the embodiment, the direction from a first semiconductor layer 21 toward a second semiconductor layer 22 is taken as a Z-axis direction (a first direction). One direction perpendicular to the Z-axis direction is taken as an X-axis direction (a second direction). A direction perpendicular to the Z-axis direction and the X-axis direction is taken as a Y-axis direction (a third direction). In the description below, the X-axis direction and the Y-axis direction are merely examples; and the X-axis direction and the Y-axis direction are not necessarily directions in which sides of the chip extend or directions along which the multiple light-receiving elements 10 are arranged. The arrangement pattern of the components of the light detector according to the embodiment is not limited to the arrangement pattern illustrated by the X-axis direction and the Y-axis direction. In the description, the direction from the first semiconductor layer 21 toward the second semiconductor layer 22 is called "up", and the opposite direction is called "down". These directions are based on the relative positional relationship between the first semiconductor layer 21 and the second semiconductor layer 22 and are independent of the direction of gravity. "Up" corresponds to the side at which a light concentrator 40 is mounted and the light is incident on the light detector. The Z-axis direction is, for example, a direction perpendicular to the front surface of the SOI substrate 20.

FIG. 3 is a schematic cross-sectional view illustrating the light detector according to the first embodiment.

FIG. 3 illustrates a cross section along line B-B' illustrated in FIG. 2. The light detector 101 according to the first embodiment is formed in the SOI (Silicon On Insulator) substrate 20 that includes the first semiconductor layer 21 as a support substrate, the second semiconductor layer 22 as an active layer, an insulating layer 23 as a BOX layer, and a void 25 formed between the first semiconductor layer 21 and the second semiconductor layer 22 by patterning a portion of the insulating layer 23. The void 25 is formed at a position in the lower portion of the light-receiving element 10. In the example of FIG. 3, the void 25 is a through-hole extending through the insulating layer 23. The void 25 is arranged with the insulating layer 23 in the X-axis direction. A gas (e.g., air) may be provided inside the void 25.

The light-receiving element 10 includes the trench T1 formed in a rectangular pattern for element separation from the adjacent light-receiving elements 10, the photoelectric conversion part 17, e.g., a vertical photodiode in which an electric field is applied in the vertical direction in the region surrounded with the trench T1, a multilevel wiring part 70 for applying the desired voltage to the photoelectric conversion part 17, the quenching part 63 connected in series between the multilevel wiring part 70 and the photoelectric conversion part 17, a third semiconductor region 13 into which a high-concentration impurity is implanted to apply a potential from the backside of the photoelectric conversion part 17, the bias region 18 formed outward of the trench to apply a potential to the third semiconductor region 13, and the light concentrator 40 concentrating the light incident from the outside on the photoelectric conversion part 17. For example, the photoelectric conversion part 17 includes a first semiconductor region 11 of the first conductivity type, and a second semiconductor region 12 and a second semiconductor layer 22a of the second conductivity type. The bias region 18 includes, for example, a fourth semiconductor region 14 and a second semiconductor layer 22b of the second conductivity type.

The photoelectric conversion part 17 is formed in the second semiconductor layer 22. The photoelectric conversion part 17 includes the first semiconductor region 11, the second semiconductor region 12, and the second semiconductor layer 22a. The second semiconductor layer 22a is a portion of the second semiconductor layer 22, and is the second semiconductor layer 22 into which an impurity is not implanted.

The second semiconductor region 12 is located on the second semiconductor layer 22a and contacts the second semiconductor layer 22a. The second semiconductor region 12 is electrically connected with the second semiconductor layer 22a. The second semiconductor region 12 is of the second conductivity type. The second-conductivity-type impurity concentration (atoms/cm³) of the second semiconductor region 12 is greater than the second-conductivity-type impurity concentration of the second semiconductor layer 22a.

The first semiconductor region 11 is located on the second semiconductor region 12 and contacts the second semiconductor region 12. The first semiconductor region 11 is electrically connected with the second semiconductor region 12. The first semiconductor region 11 is of the first conductivity type.

A p-n junction is formed at the interface between the first semiconductor region 11 and the second semiconductor region 12. A photodiode is formed of the first and second semiconductor regions 11 and 12 (and the second semiconductor layer 22a and the third semiconductor region 13). The photodiode includes a light-receiving surface 10f. The light-receiving surface 10f is the upper surface of the first semiconductor region 11. The light-receiving surface 10f is a portion of an upper surface 22f of the second semiconductor layer 22 and is a portion of the upper surface 22f of the second semiconductor layer 22 that includes the photoelectric conversion part 17 surrounded with the trench T1.

The photoelectric conversion part 17 is positioned above the void 25. In other words, the photoelectric conversion part 17 is arranged in the Z-axis direction with the void 25. At least a portion of the void 25 overlaps the photoelectric conversion part 17 in the Z-axis direction.

The third semiconductor region 13 and the bias region 18 also are formed in the second semiconductor layer 22. The bias region 18 includes the fourth semiconductor region 14 and the second semiconductor layer 22b. The second semiconductor layer 22b is a portion of the second semiconductor layer 22 into which an impurity is not implanted; and the impurity concentration of the second semiconductor layer 22b contacting the fourth semiconductor region 14 is less than the second-conductivity-type impurity concentration of the fourth semiconductor region 14. The third semiconductor region 13 is located between the insulating layer 23 and the photoelectric conversion part 17; and the photoelectric conversion part 17 is positioned above a portion of the third semiconductor region 13. The third semiconductor region 13 contacts the second semiconductor layer 22a and is electrically connected with the second semiconductor layer 22a. The third semiconductor region 13 is of the second conductivity type. The second-conductivity-type impurity concentration (atoms/cm³) of the third semiconductor region 13 is greater than the second-conductivity-type impurity concentration of the second semiconductor layer 22a.

The bias region 18 is arranged with the photoelectric conversion part 17 in the X-axis direction. The bias region 18 is located on a portion of the third semiconductor region 13. The fourth semiconductor region 14 of the bias region 18 contacts the third semiconductor region 13 and is electrically connected with the third semiconductor region 13. The fourth semiconductor region 14 is of the second conductivity type. For example, the second-conductivity-type impurity concentration of the fourth semiconductor region 14 is greater than the second-conductivity-type impurity concentration of the second semiconductor layer 22b. The second-conductivity-type impurity concentration of the fourth semiconductor region 14 may be less than the second-conductivity-type impurity concentration of the second semiconductor region or may be less than the second-conductivity-type impurity concentration of the third semiconductor region. The fourth semiconductor region 14 extends in the Z-axis direction from the upper surface 22f of the second semiconductor layer 22 to the third semiconductor region 13.

The trench T1 is a structure body located on a portion of the third semiconductor region 13. The trench T1 is arranged with the photoelectric conversion part 17 in a direction crossing the Z-axis direction. For example, the trench T1 extends in the Z-axis direction from the upper surface 22f of the second semiconductor layer 22 to the third semiconductor region 13. The lower end of the trench T1 contacts the third semiconductor region 13.

For example, the trench T1 surrounds the photoelectric conversion part 17. In the example, the trench T1 has a ring shape surrounding the photoelectric conversion part 17 in the X-Y plane perpendicular to the Z-axis direction (see FIG. 2). For example, the trench T1 contacts the first semiconductor region 11, the second semiconductor region 12, and the second semiconductor layer 22a. However, the first semiconductor region 11 and the second semiconductor region 12 may be separated from the trench T1.

The trench T1 includes a different material from the semiconductor regions of the second semiconductor layer 22. The trench T1 is insulative and includes, for example, an insulating body. The refractive index of the trench T1 is different from the refractive indexes of the semiconductor regions of the second semiconductor layer 22. The refractive index of the trench T1 is different from the refractive index of the photoelectric conversion part 17. That is, the refractive index of the trench T1 is different from the refractive indexes of the first semiconductor region 11, the second semiconductor region 12, and the second semiconductor layer 22a. At least a portion of the trench T1 may be hollow.

Although the bottom portion of the trench T1 reaches, for example, a region that is deeper than the depth to which the depletion layer spreads when a reverse bias is applied, the bottom portion of the trench T1 stops in the second semiconductor layer 22 and does not extend to the insulating layer 23. In other words, the second semiconductor layer 22 or the third semiconductor region 13 is under the bottom portion of the trench T1. The interior of the trench T1 is filled with an insulating film, and although not illustrated, an impurity may be implanted to cover the trench T1 to repair defects of the bottom portion and the sidewall of the trench T1.

The second semiconductor layer 22b, i.e., a portion of the second semiconductor layer 22, may be located between the fourth semiconductor region 14 and the trench T1. In other words, the bias region 18 may or may not include the second semiconductor layer 22b, and may include an impurity region formed to repair defects.

The multilevel wiring part 70 is located on the second semiconductor layer 22, and is a stacked structure on a silicon substrate formed by a metal wiring process of a general semiconductor process. For example, the multilevel wiring part 70 is formed from an insulating layer 30, the quenching part 63, a contact hole 60, the first wiring layer 51, an interlayer interconnect 68, the second wiring layer 52, the first electrode pad 55, the second electrode pad 56, etc., described above.

The photoelectric conversion parts 17 of the light-receiving elements 10 are connected in series to the quenching parts 63 via the contact holes 60 and the first wiring layers 51 at the front surface of the first semiconductor regions 11, and are further connected in parallel via the contact holes 60 and the first wiring layers 51 to a read signal line formed of the first wiring layer 51, the interlayer interconnects 68, and the second wiring layer 52; for example, the read signal line is connected to the first electrode pad 55. Here, for example, read signal line means a signal line patterned and connected using conductive wiring from the first electrode pad 55 such as the first wiring layer 51, the second wiring layer 52, etc., inside the multilevel wiring part 70. In other words, the first semiconductor region 11 of the first conductivity type of the photoelectric conversion part 17 is electrically connected with one end of the quenching part 63 via the contact holes 60 and the first wiring layer 51. The other end of the quenching part 63 is electrically connected with the first wiring layer 51 via the contact hole 60. The first wiring layer 51 is electrically connected with the first electrode pad 55 via the interlayer interconnect 68 and the second wiring layer 52.

At the second semiconductor layers 22a of the photoelectric conversion parts 17, for example, a bias signal line made of the first wiring layer 51, the interlayer interconnects 68, and the second wiring layer 52 and connected with the second electrode pad 56 is connected in parallel to the front surfaces of the fourth semiconductor regions 14 of the bias regions 18 via the contact holes 60 and the first wiring layers 51; and the fourth semiconductor regions 14 that have a lower resistance are connected to the second semiconductor regions 12 of the photoelectric conversion parts 17 via the third semiconductor regions 13. Here, for example, bias signal line means a signal line patterned and connected from the second electrode pad 56 by conductive wiring such as the first wiring layer 51, the second wiring layer 52, etc., inside the multilevel wiring part 70. In other words, the second semiconductor region 12 of the second conductivity type of the photoelectric conversion part 17 is electrically connected with the second electrode pad 56 via the second semiconductor layer 22a, the third semiconductor region 13, and the fourth semiconductor region 14 of the same second conductivity type, and via the metal wiring inside the multilevel wiring part 70.

The light concentrator 40 is located on the multilevel wiring part 70. The light concentrator 40 is positioned above the photoelectric conversion part 17. For example, the light concentrator 40 is an upwardly convex lens (e.g., a microlens). For example, the light concentrator 40 can concentrate at least a portion of the light incident on the light concentrator 40 toward the photoelectric conversion part 17. For example, the light concentrator 40 causes the light entering through the upper surface of the light concentrator 40 to travel toward the photoelectric conversion part 17 by refracting the light.

As illustrated in FIG. 3, one element structure includes a portion of the first semiconductor layer 21, a portion of the insulating layer 23, a portion of the third semiconductor region, one photoelectric conversion part 17, one trench T1, one quenching part 63, a portion of the insulating layer 30, and one light concentrator 40. Such an element structure is repeatedly provided. For example, as illustrated in FIGS. 1 and 2, the multiple element structures are arranged in an array configuration along the X-Y plane. For example, the multiple element structures are periodically arranged at a uniform pitch.

Materials of the components of the light detector 101 will now be described.

The first semiconductor layer 21 and the second semiconductor layer 22 include at least one semiconductor material selected from the group consisting of silicon, silicon carbide, gallium arsenide, and gallium nitride. For example, the first semiconductor layer 21 and the second semiconductor layer 22 include silicon. The insulating layer 23 includes an insulating material. The insulating layer 23 includes, for example, silicon and one selected from the group consisting of oxygen and nitrogen. The insulating layer 23 includes, for example, silicon oxide.

Specifically, the SOI (Silicon On Insulator) substrate 20 can be used as the first semiconductor layer 21, the second semiconductor layer 22, and the insulating layer 23. The first semiconductor layer 21 is, for example, a support substrate that includes silicon. The insulating layer 23 is, for example, a buried oxide film (a BOX layer) that includes silicon oxide. The second semiconductor layer 22 is, for example, an epitaxial layer that includes silicon. The first semiconductor region 11 is obtained by implanting an n-type impurity into silicon. For example, at least one of the Group V elements of phosphorus, arsenic, or antimony can be used as the n-type impurity. The second semiconductor region 12, the third semiconductor region 13, and the fourth semiconductor region 14 each are obtained by implanting a p-type impurity into silicon. For example, the Group III element of boron can be used as the p-type impurity.

The trench T1 includes a different material from the material of the second semiconductor layer 22. Specifically, the trench T1 includes an insulating material. For example, the trench T1 includes silicon and one selected from the group consisting of oxygen and nitrogen. For example, the trench T1 includes silicon oxide or silicon nitride. The trench T1 may have a stacked structure.

The insulating layer 30 includes, for example, a light-transmissive material. For example, the insulating layer 30 includes silicon and one selected from the group consisting of oxygen and nitrogen. For example, the insulating layer 30 includes at least one of silicon oxide or silicon nitride.

The first electrode pad 55, the second electrode pad 56, the first wiring layer 51, the second wiring layer 52, the contact hole 60, and the interlayer interconnect 68 each include, for example, at least one metal selected from the group consisting of titanium, tungsten, copper, gold, aluminum, indium, and tin.

In the example, a quenching resistance is used as the quenching part 63. The quenching resistance is, for example, not less than 1 kQ and not more than 10 MΩ. The quenching resistance includes, for example, polysilicon as a semiconductor material. An n-type impurity or a p-type impurity may be added to the quenching resistance. The fourth semiconductor region 14 may be used as the quenching resistance by controlling the impurity concentration of the fourth semiconductor region 14. In FIG. 3, the quenching resistance is formed between the second semiconductor layer 22 and the first wiring layer 51 above the trench T1, but the arrangement is intended not to shield the light irradiated on the photoelectric conversion part 17, and in the case where, for example, the light concentrator 40 can concentrate the light or when the quenching resistance is formed of a material having high transmissivity, the quenching resistance may be formed on the photoelectric conversion part 17.

The light concentrator 40 includes a light-transmissive material. For example, the light concentrator 40 includes a light-transmissive organic material such as a photoresist of a photosensitive material, a high refractive index resin, etc. A portion of the front surface of the insulating layer 30 may be used as the light concentrator 40 by patterning into a lens shape, etc.

Because the third semiconductor region 13 functions as a bias electrode of the photoelectric conversion part 17, it is favorable for the third semiconductor region 13 to have a high impurity concentration, a large pattern, and a lower resistance. Because the fourth semiconductor region 14 is intended to supply the bias signal from the pad to the third semiconductor region 13 without electrical loss, the fourth semiconductor region 14 is connected with the same conductivity type as the third semiconductor region 13. The connection of the third and fourth semiconductor regions 13 and 14 of FIG. 3 is conceptual and is not limited to this cross-sectional structure; for example, a structure in which a region of the same impurity concentration as the second semiconductor layer 22 is located between the third semiconductor region 13 and the fourth semiconductor region 14 also is included in the embodiment. In other words, any region that separates the elements, has a high impurity concentration from the front surface, and is of the same conductivity type as the second semiconductor layer 22 is the fourth semiconductor region 14 and is included in the embodiment as long as the third and fourth semiconductor regions 13 and 14 are not physically separated by an insulating film, etc.

Operations of the light detector 101 will now be described.

The incident light that is incident on the upper surface of the light concentrator 40 from above is concentrated toward the photoelectric conversion part 17 by the light concentrator 40. The incident light that is incident on the upper surface of the light concentrator 40 passes through the light concentrator 40 and the insulating layer 30 and enters the photoelectric conversion part 17 through the light-receiving surface 10f.

For example, the incident light is near-infrared light. The wavelength of the near-infrared light is, for example, not less than 0.7 micrometers (µm) and not more than 2.5 µm. However, according to the embodiment, the incident light is not necessarily near-infrared light.

For example, the photoelectric conversion part 17 functions as a p-i-n diode or an avalanche photodiode. A charge is generated by photoelectric conversion occurring in the photoelectric conversion part 17 when the light is incident on the photoelectric conversion part 17. When the charge is generated, a current flows in the wiring parts and the like (a conductive part 61, the quenching part 63, and the first wiring layer 51) electrically connected with the first semiconductor region 11. The incidence of the light on the photoelectric conversion part 17 can be detected by detecting the current flowing in the wiring part and the like as an output.

The first electrode pad 55 and the second electrode pad 56 drive the light-receiving element 10 by applying a voltage to the first and second semiconductor regions 11 and 12. For example, the voltage can be applied between the first semiconductor region 11 and the second semiconductor region 12 by controlling the potential of the second electrode pad 56. A reverse voltage that is greater than the breakdown voltage may be applied between the first semiconductor region 11 and the second semiconductor region 12. In other words, the photoelectric conversion part 17 may include an avalanche photodiode that operates in a Geiger mode. By operating in a Geiger mode, a pulse signal of a high multiplication factor (i.e., a high gain) is output. The light-receiving sensitivity of the light detector can be increased thereby.

The quenching part 63 is provided to suppress the continuation of avalanche breakdown when light is incident on the photoelectric conversion part 17 and avalanche breakdown occurs. When avalanche breakdown occurs and a current flows in the quenching part 63, a voltage drop that corresponds to the electrical resistance of the quenching part 63 occurs. The potential difference between the first semiconductor region 11 and the second semiconductor region 12 is reduced by the voltage drop; and the avalanche breakdown stops. The next light that is incident on the photoelectric conversion part 17 can be detected thereby.

A portion of the incident light incident on the photoelectric conversion part 17 is reflected (e.g., totally reflected) by the trench T1 at the interface between the trench T1 and the photoelectric conversion part 17 and further travels through the photoelectric conversion part 17. For example, the optical path length of the incident light inside the photoelectric conversion part 17 can be increased thereby, and the sensitivity of the light detector can be increased.

Conduction and optical interference between the adjacent photoelectric conversion parts 17 can be suppressed by the trench T1. For example, the movement of secondary photons and carriers between the photoelectric conversion parts 17 is suppressed by the trench T1. When light is incident on the photoelectric conversion part 17 and secondary photons are generated, the secondary photons that travel toward the adjacent photoelectric conversion parts 17 are reflected and refracted at the interface of the trench T1. By providing the trench T1, the crosstalk noise can be reduced.

According to the embodiment as described above, the void 25 is positioned between the photoelectric conversion part 17 and a portion of the first semiconductor layer 21. In other words, the photoelectric conversion part 17 is positioned above the void 25. The light that is incident on the photoelectric conversion part 17 from above and travels downward passes through the photoelectric conversion part 17 toward the void 25. A portion of the light is reflected upward by the refractive index difference at the interface between the void 25 and the layer (in the example of FIG. 3, the second semiconductor layer 22) directly above the void 25 and again travels through the photoelectric conversion part 17. For example, the optical path length of the incident light inside the photoelectric conversion part 17 can be increased thereby, and the sensitivity of the light detector can be increased. For example, the probability of the photons incident on the photoelectric conversion part 17 being detected is increased, and the absorbed light intensity (the number of absorbed photons) of the photoelectric conversion part 17 is increased.

In the example, the void 25 is provided to extend through the insulating layer 23. Although there are cases where the manufacturing difficulty is high when causing an oxide film to remain in etching, it is favorable for the void to extend through the insulating layer 23 because the manufacturing is easy. For example, when an oxide film and silicon are used, the etching selectivity can be high. The thickness of the void 25 is equal to the thickness of the insulating layer 23. The thickness refers to the length along the Z-axis direction.

For example, the light-receiving element 10 has a Si/Air/Si structure in which the void 25 (Air) is interposed between the photoelectric conversion part 17 (Si) and the first semiconductor layer 21 (Si). Therefore, by using the void 25 that is of a different material, the light that passes through without being absorbed by the photoelectric conversion part 17 can be reflected upward at the interface between the second semiconductor layer 22 and the void 25 and at the interface between the void 25 and the first semiconductor layer 21; and the sensitivity is improved by detecting the reflection component.

Multiple voids 25 are provided in the light detector 101. The multiple photoelectric conversion parts 17 are positioned respectively above the multiple voids 25. In other words, one void 25 is located below one photoelectric conversion part 17. For example, the adhesion between the layer in which the void is provided and the layer that contacts the layer of the void can be improved thereby. For example, as illustrated in FIG. 3, the insulating layer 23 is arranged in the Z-axis direction with at least one of the fourth semiconductor region 14 or the trench T1. For example, the insulating layer 23 is positioned between the adjacent voids 25. In the example of FIG. 3, the upper surface of the insulating layer 23 contacts the second semiconductor layer 22; and the lower surface of the insulating layer 23 contacts the first semiconductor layer 21. Thereby, for example, compared to when the insulating layer 23 is not included, the adhesion between the insulating layer 23 and the second semiconductor layer 22 and the adhesion between the insulating layer 23 and the first semiconductor layer 21 can be improved.

For example, the multiple voids 25 are arranged in an array configuration along the X-Y plane according to the arrangement of the multiple photoelectric conversion parts 17. In such a case, the insulating layer 23 has a lattice shape in the X-Y plane. The insulating layer 23 may not be arranged with the photoelectric conversion part 17 in the Z-axis direction.

According to the embodiment as described above, the fourth semiconductor region 14 is located on the third semiconductor region 13. The trench T1 is provided on the third semiconductor region 13 and positioned between the fourth semiconductor region 14 and the photoelectric conversion part 17. In other words, the third semiconductor region 13 is positioned between the insulating layer 23 and the second semiconductor region 12, between the insulating layer 23 and the trench T1, and between the insulating layer 23 and the fourth semiconductor region 14. Thereby, the fourth semiconductor region 14 and the photoelectric conversion part 17 can be electrically connected via a portion of the third semiconductor region 13 under the trench T1. Even when the insulating layer 23 is located below the photoelectric conversion part 17, the voltage can be applied to the photoelectric conversion part 17 from the upper surface 22f side of the second semiconductor layer 22.

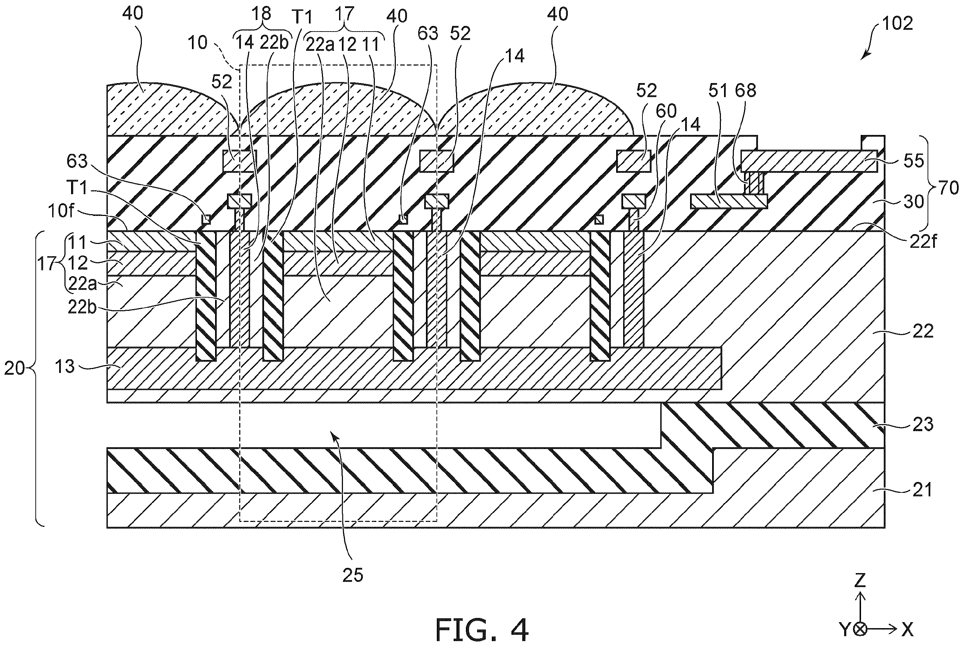

The configuration of the SOI substrate 20 used when manufacturing the light detector of FIG. 3 is different between FIGS. 4 to 6. A description of the device interior is omitted because only the configuration of the SOI substrate 20 is different, and the method for manufacturing the light detector is not modified at all for the configurations of the second semiconductor layer 22 interior, the multilevel wiring part 70, and the light concentrator 40.

FIG. 4 is a schematic cross-sectional view illustrating a light detector according to the first embodiment.

The shape of the void 25 (the insulating layer 23 and the first semiconductor layer 21) of the light detector 102 illustrated in FIG. 4 is different from that of the light detector 101 illustrated in FIG. 3.

In the light detector 102 as illustrated in FIG. 4, the void 25 is provided in the upper portion of the insulating layer 23. A portion of the void 25 is located between the photoelectric conversion part 17 and a portion of the insulating layer 23. In other words, for example, the light detector 102 has a Si/Air/SiO₂/Si structure in which the void 25 (Air) and the insulating layer 23 (SiO₂) are interposed between the photoelectric conversion part 17 (Si) and the first semiconductor layer 21 (Si). The sensitivity of the light detector can be further improved thereby. For example, the light that travels downward can be reflected upward at the interface between the second semiconductor layer 22 and the void 25, the interface between the void 25 and the insulating layer 23, and the interface between the insulating layer 23 and the first semiconductor layer 21.

In the example, multiple photoelectric conversion parts 17 are located above one void 25. In other words, the void 25 is arranged in the Z-axis direction with the multiple photoelectric conversion parts 17, the multiple trenches T1, and the fourth semiconductor region 14.

The insulating layer 23 includes a region contacting the second semiconductor layer 22 and a region contacting the void 25. The void 25 is the space between the second semiconductor layer 22 and a portion of the insulating layer 23. Multiple photoelectric conversion parts 17 are located above one void 25. The thickness of the void 25 below one photoelectric conversion part 17 may be equal to the thickness of the insulating layer 23, less than the thickness of the insulating layer 23, or greater than the thickness of the insulating layer 23.

For example, compared to the light detector 101 in which one photoelectric conversion part 17 is located above the one void 25 illustrated in FIG. 3, the degree of freedom of the size of the photoelectric conversion part 17 can be increased thereby, and an increase of the manufacturing difficulty can be suppressed. It is necessary to reduce the size of the void 25 as the photoelectric conversion part 17 of the light detector 101 becomes smaller, and there is a possibility that the manufacturing difficulty of the SOI substrate 20 may increase. On the other hand, by using a structure in which one void 25 is provided for the multiple photoelectric conversion parts 17 (the light-receiving elements 10) as in the light detector 102, the size of the void 25 can be easily increased without affecting the size of the photoelectric conversion part 17; and manufacturing of the SOI substrate 20 is therefore easier. Also, the alignment between the void 25 and the photoelectric conversion part 17 is easier when manufacturing the light detector 102.

In the manufacturing processes of the SOI substrate 20, for example, the SOI substrate 20 can be realized by patterning the first semiconductor layer 21 as a support substrate, subsequently forming the insulating layer 23 as a BOX layer by heat treatment, and bonding the second semiconductor layer 22 as an active layer by heat treatment. Thereby, compared to the manufacturing process of the SOI substrate 20 illustrated in FIG. 3, the insulating layer 23 is formed after pre-patterning the first semiconductor layer 21; therefore, for example, the risk of causing film quality degradation when patterning the insulating layer 23 and the like are eliminated. Also, optimization is easier because the thickness of the void 25 can be arbitrarily controlled regardless of the thickness of the insulating layer 23.

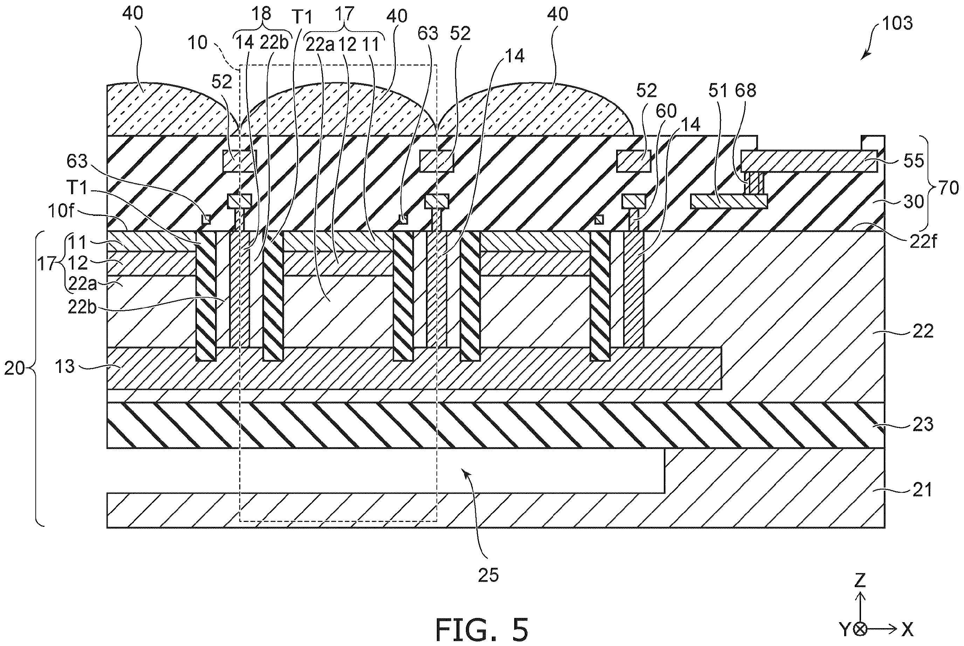

FIG. 5 is a schematic cross-sectional view illustrating a light detector according to the first embodiment.

The shape of the void 25 (the insulating layer 23 and the first semiconductor layer 21) of the light detector 103 illustrated in FIG. 5 is different from that of the light detector 101 illustrated in FIG. 3.

In the light detector 103 as illustrated in FIG. 5, the void 25 is provided in the first semiconductor layer 21 under the insulating layer 23. A portion of the void 25 is located between the photoelectric conversion part 17 and a portion of the first semiconductor layer 21. A portion of the insulating layer 23 is located between the photoelectric conversion part 17 and the portion of the void 25. In other words, for example, the light detector 103 has a Si/SiO₂/Air/Si structure in which the insulating layer 23 (SiO₂) and the void 25 (Air) are interposed between the photoelectric conversion part 17 (Si) and the first semiconductor layer 21 (Si). The sensitivity of the light detector can be further improved thereby. For example, the light that travels downward can be reflected upward at the interface between the second semiconductor layer 22 and the insulating layer 23, the interface between the insulating layer 23 and the void 25, and the interface between the void 25 and the first semiconductor layer 21.

In the example, multiple photoelectric conversion parts 17 are located above one void 25. In other words, the void 25 is arranged in the Z-axis direction with the multiple photoelectric conversion parts 17, the multiple trenches T1, and the fourth semiconductor region 14.

In the manufacturing processes of the SOI substrate 20, for example, the SOI substrate 20 can be realized by patterning the first semiconductor layer 21 as a support substrate, performing heat treatment to form the insulating layer 23 as a BOX layer on the second semiconductor layer 22 used as an active layer, and bonding with the first semiconductor layer 21 by heat treatment. Thereby, compared to the manufacturing process of the SOI substrate 20 illustrated in FIG. 3, the first semiconductor layer 21 is patterned and then bonded; therefore, for example, the risk of film quality degradation when patterning the insulating layer 23 and the like are eliminated. Also, optimization is easier because the thickness of the void 25 can be arbitrarily controlled regardless of the thickness of the insulating layer 23.

In FIGS. 3 to 5, the void 25 (the hollow or space) is included between the first semiconductor layer 21 and the second semiconductor layer 22 by etching at least one of the first semiconductor layer 21 or the insulating layer 23. In the example of FIG. 3, the void 25 is provided in a region where the insulating layer 23 is patterned by etching. As in the examples of FIGS. 4 and 5, the void 25 may be provided by etching the first semiconductor layer 21.

Although one void 25 is provided for one photoelectric conversion part 17 in FIG. 3 and one void 25 is provided for multiple photoelectric conversion parts 17 in FIGS. 4 and 5, such combinations may be different according to the configuration of the SOI substrate 20.

Although one of the upper surface or the lower surface of the void 25 contacts the first semiconductor layer 21 or the second semiconductor layer 22 in FIGS. 3 to 5, this configuration is an example; a film of an insulator material, e.g., an oxide film (the insulating layer 23), may be located between the void 25 and the first semiconductor layer 21 or the second semiconductor layer 22. This is similar for the side surface of the void 25 as well.

Multiple voids 25 may be provided below one photoelectric conversion part 17.

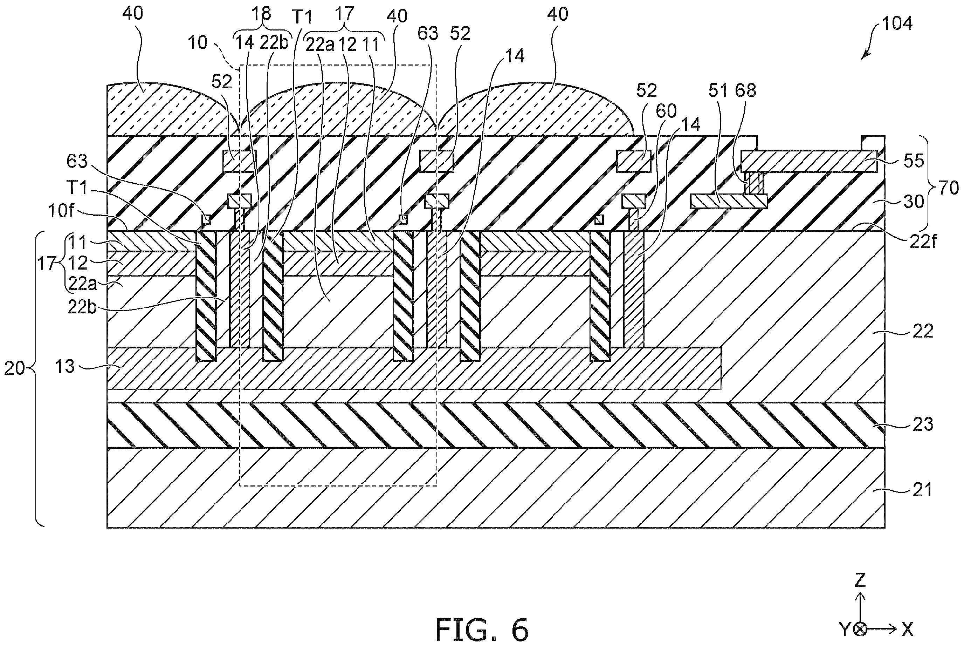

FIG. 6 is a schematic cross-sectional view illustrating a light detector according to the first embodiment.

The light detector 104 illustrated in FIG. 6 differs from the light detector 101 illustrated in FIG. 3 in that the void 25 is not provided.

A portion of the insulating layer 23 is positioned between the photoelectric conversion part 17 and a portion of the first semiconductor layer 21. The portion of the insulating layer 23 contacts the first and second semiconductor layers 21 and 22. In other words, for example, the light detector 104 has a Si/SiO₂/Si structure in which the insulating layer 23 (SiO₂) is interposed between the photoelectric conversion part 17 (Si) and the first semiconductor layer 21 (Si). The sensitivity of the light detector can be increased thereby. For example, the light that travels downward can be reflected upward at the interface between the second semiconductor layer 22 and the insulating layer 23 and the interface between the insulating layer 23 and the first semiconductor layer 21.

Although a method for manufacturing the SOI substrate is described herein, the description is merely an example of the manufacturing method and does not limit the manufacturing method. The intent of the description is to show that the light detector is manufactured using SOI substrates such as those shown in FIGS. 3 to 6 without any modification to the method for manufacturing the light detector.

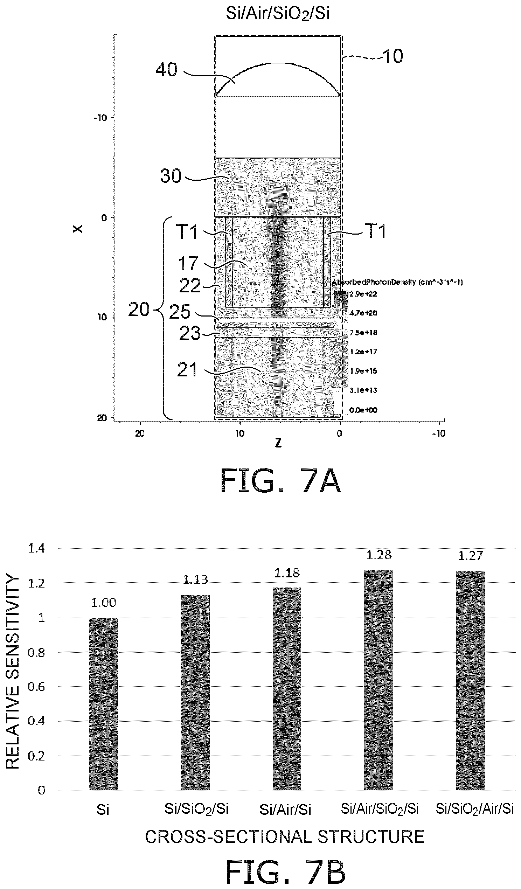

FIGS. 7A and 7B are schematic views illustrating a simulation of the light detector.

FIG. 7A is a cross-sectional distribution diagram of the absorbed photon density of near-infrared light (905 nm) determined by a TCAD simulation using the light-receiving element 10 having the Si/Air/SiO₂/Si structure of FIG. 4 as a calculation model. The absorbed photon density is high in the central region of the photoelectric conversion part. This is a result of the light concentrator concentrating the light in the photodiode central region. The sensitivity (the photon detection efficiency) is determined by integrating the avalanche probability of the photoelectric conversion part and the absorbed photon density obtained by the simulation. FIG. 7B is a graph showing the relative sensitivity characteristics of near-infrared light (905 nm) for the light-receiving element 10 structures of FIGS. 3 to 6, in which the sensitivity when a conventional general silicon substrate is manufactured is taken to be 1. The Si/Air/SiO₂/Si of FIG. 4 had the greatest sensitivity; and a sensitivity increase of about 30% over the conventional structure was confirmed. A sensitivity improvement of not less than 10% over the conventional structure was confirmed for all of the other structures.

The simulation result is the result of an example of the embodiment; of course, the sensitivity improvement ratio changes according to the wavelength of the irradiated light, the shape of the light concentrator, the characteristics of the photoelectric conversion part, etc. However, for light of the near-infrared region, an improvement of the sensitivity over the conventional structure is confirmed in each case.

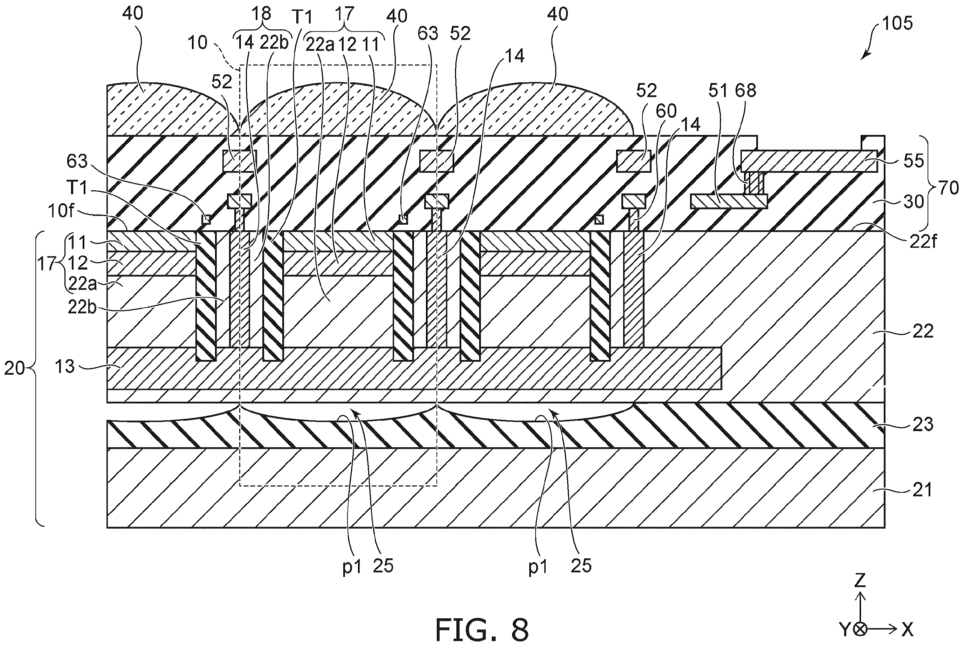

Examples of structures will now be described with reference to FIGS. 8 to 12. However, the following descriptions related to FIGS. 8 to 12 are examples; and the light detector according to the embodiment is not limited to the description below.

In FIGS. 8 to 12, the configurations of the SOI substrate 20 used to manufacture the light detector of FIG. 3 are different. A description of the device interior is omitted because only the configuration of the SOI substrate 20 is different, and the method for manufacturing the light detector is not modified at all for the configurations of the second semiconductor layer 22 interior, the multilevel wiring part 70, and the light concentrator 40.

FIG. 8 is a schematic cross-sectional view illustrating a light detector according to the first embodiment.

The shape of the void 25 (the insulating layer 23) of the light detector 105 illustrated in FIG. 8 is different from that of the light detector 101 illustrated in FIG. 3.

In the light detector 105 as illustrated in FIG. 8, multiple concave voids 25 are provided in the upper portion of the insulating layer 23. The multiple photoelectric conversion parts 17 are positioned respectively above the multiple voids 25.

The void 25 does not extend through the insulating layer 23. The thickness of the void 25 is less than the thickness of the insulating layer 23. The multiple photoelectric conversion parts 17 are positioned respectively above the multiple voids 25. For example, a center point p1 in the X-Y plane of one void 25 matches the center of the photoelectric conversion part 17. For example, the center point p1 is the lowermost portion of the void 25. The void 25 is a curved surface that is concave downward.

In the manufacturing processes of the SOI substrate 20, the SOI substrate 20 of FIG. 8 is realized by patterning a portion of the insulating layer 23 used as a BOX layer into a spherical shape by isotropic etching and by bonding by heat treatment to the second semiconductor layer 22 used as an active layer. In FIG. 8, the void 25 is formed between the insulating layer 23 and the second semiconductor layer 22; and the structure of the light-receiving element 10 from the second semiconductor layer 22 to the first semiconductor layer 21 is the second semiconductor layer 22, the void 25, the insulating layer 23, and the first semiconductor layer 21 in this order, and is Si/Air/SiO₂/Si in order of material.

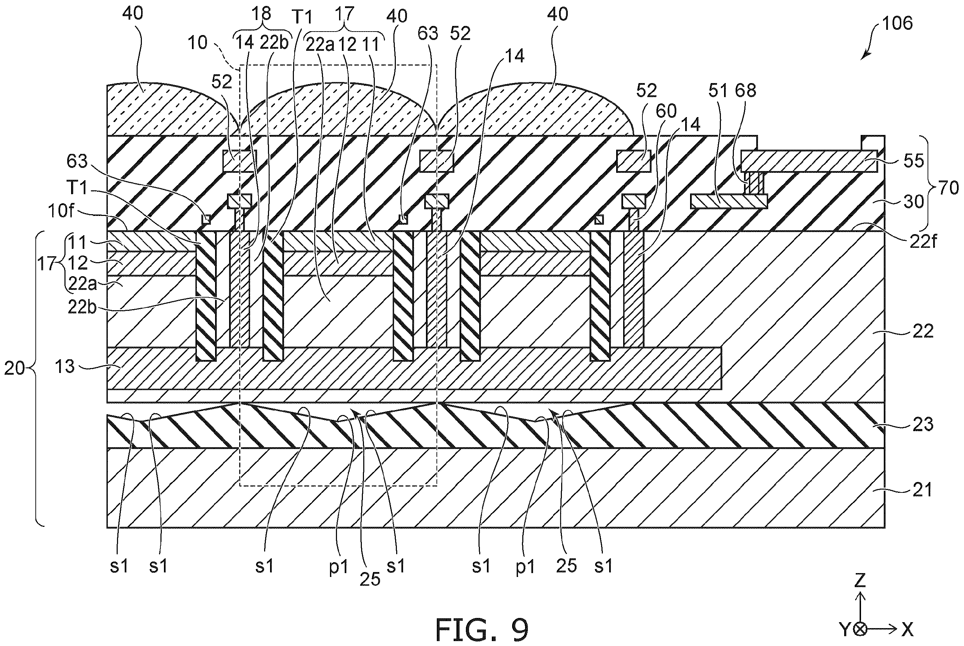

FIG. 9 is a schematic cross-sectional view illustrating a light detector according to the first embodiment.

The shape of the void 25 (the insulating layer 23) of the light detector 106 illustrated in FIG. 9 is different from that of the light detector 105 illustrated in FIG. 8.

In the light detector 106, multiple concave voids 25 are provided in the upper portion of the insulating layer 23. In the example, the void 25 includes multiple oblique surfaces s1. The oblique surface s1 is oblique to the Z-axis direction and oblique to the X-Y plane. The oblique surface s1 is, for example, a plane. For example, the center point p1 in the X-Y plane of the void 25 is at the intersection of the multiple oblique surfaces s1.

In the manufacturing processes of the SOI substrate 20, the SOI substrate 20 of FIG. 9 is realized by patterning a portion of the insulating layer 23 used as a BOX layer into a shape having oblique surfaces by anisotropic etching and by bonding by heat treatment to the second semiconductor layer 22 used as an active layer. In FIG. 9, the void 25 is formed between the insulating layer 23 and the second semiconductor layer 22; and the structure of the light-receiving element 10 from the second semiconductor layer 22 to the first semiconductor layer 21 is the second semiconductor layer 22, the void 25, the insulating layer 23, and the first semiconductor layer 21 in this order, and is Si/Air/SiO₂/Si in order of material.

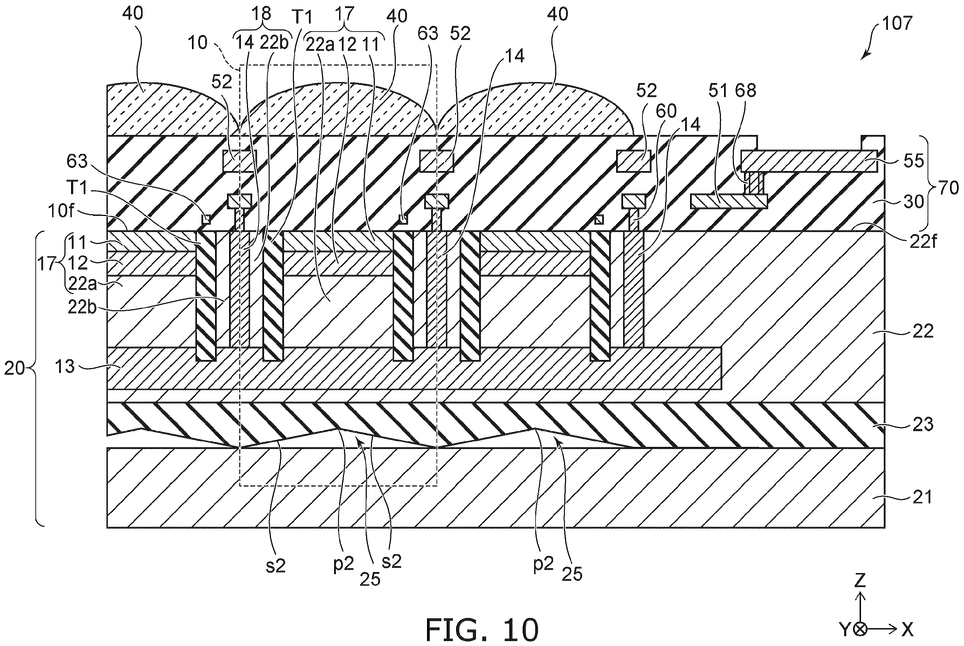

FIG. 10 is a schematic cross-sectional view illustrating a light detector according to the first embodiment.

The shape of the void 25 (the insulating layer 23) of the light detector 107 illustrated in FIG. 10 is different from that of the light detector 101 illustrated in FIG. 3.

In the light detector 107, multiple convex voids 25 are provided in the lower portion of the insulating layer 23. The multiple photoelectric conversion parts 17 are positioned respectively above the multiple voids 25.

The void 25 does not extend through the insulating layer 23. The thickness of the void 25 is less than the thickness of the insulating layer 23. The void 25 contacts the first semiconductor layer 21. For example, a center point p2 in the X-Y plane of one void 25 matches the center of the photoelectric conversion part 17 in the X-Y plane. For example, the center point p2 is positioned at the highest portion of the void 25. The void 25 includes multiple oblique surfaces s2. The oblique surface s2 is oblique to the Z-axis direction and oblique to the X-Y plane. The oblique surface s2 is, for example, a plane. The center point p2 in the X-Y plane of the void 25 is, for example, the intersection of the multiple oblique surfaces s2. The void 25 may be a curved surface that is concave upward.

In the manufacturing processes of the SOI substrate 20, the SOI substrate 20 of FIG. 10 is realized by forming the insulating layer 23 as a BOX layer on the substrate used to form the second semiconductor layer 22 as an active layer, patterning a portion of the insulating layer 23 into a shape including oblique surfaces by anisotropic etching, and bonding by heat treatment to the first semiconductor layer 21 used as a support substrate. In FIG. 10, the void is formed between the first semiconductor layer 21 and the insulating layer 23; and the structure of the light-receiving element 10 from the second semiconductor layer 22 to the first semiconductor layer 21 is the second semiconductor layer 22, the insulating layer 23, the void 25, and the first semiconductor layer 21 in this order, and is Si/SiO₂/Air/Si in order of material.

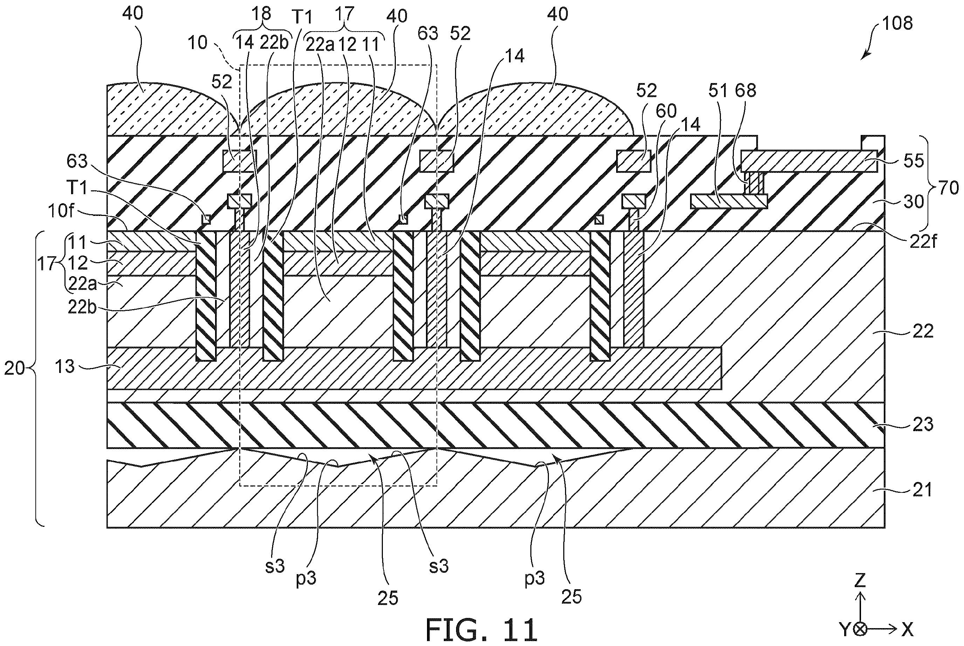

FIG. 11 is a schematic cross-sectional view illustrating a light detector according to the first embodiment.

The shape of the void 25 (the first semiconductor layer 21) of the light detector 108 illustrated in FIG. 11 is different from that of the light detector 105 illustrated in FIG. 8.

In the light detector 108, the multiple concave voids 25 are provided in the upper portion of the first semiconductor layer 21. The multiple photoelectric conversion parts 17 are positioned respectively above the multiple voids 25.

The portions between the mutually-adjacent voids 25 contact the insulating layer 23. The lower surface of the insulating layer 23 may be a plane extending along the X-Y plane. For example, a center point p3 in the X-Y plane of one void 25 matches the center of the photoelectric conversion part 17 in the X-Y plane. For example, the center point p3 is positioned at the lowermost portion of the void 25. The void 25 includes multiple oblique surfaces s3. The oblique surface s3 is oblique to the Z-axis direction and oblique to the X-Y plane. The oblique surface s3 is, for example, a plane. The center point p3 in the X-Y plane of the void 25 is, for example, the intersection of the multiple oblique surfaces s3. The void 25 may be a curved surface that is concave downward.

In the manufacturing processes of the SOI substrate 20, the SOI substrate 20 of FIG. 11 is realized by forming the insulating layer 23 as a BOX layer on the substrate used to form the second semiconductor layer 22 as an active layer, patterning a portion of the first semiconductor layer 21 to be bonded as the support substrate into a shape including oblique surfaces by anisotropic etching and wet etching, and performing heat treatment to bond. In FIG. 11, the void 25 is formed between the first semiconductor layer 21 and the insulating layer 23; and the structure of the light-receiving element 10 from the second semiconductor layer 22 to the first semiconductor layer 21 is the second semiconductor layer 22, the insulating layer 23, the void 25, and the first semiconductor layer 21 in this order, and is Si/SiO₂/Air/Si in order of material.

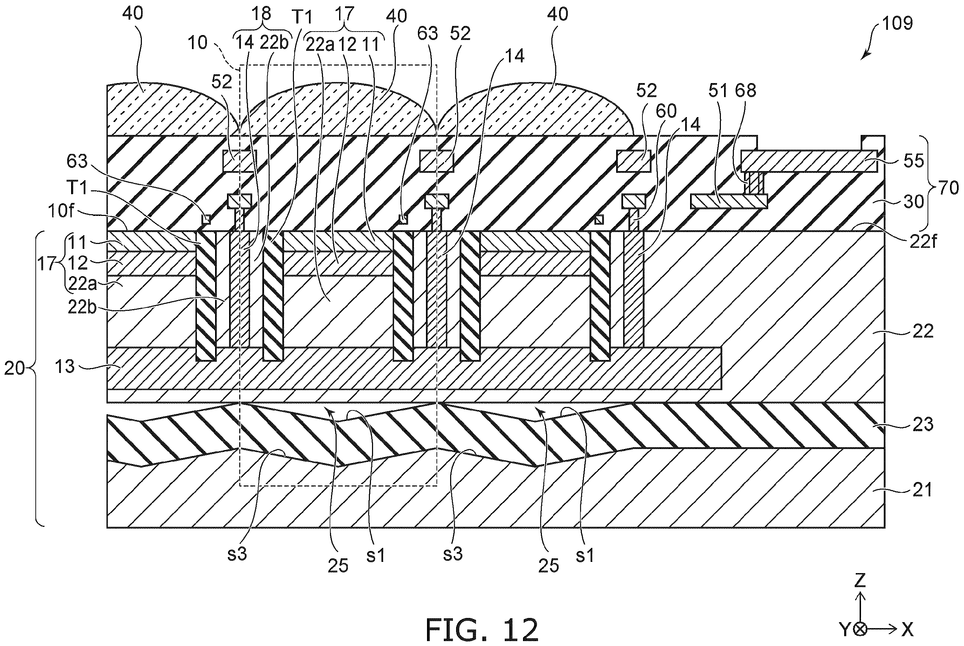

FIG. 12 is a schematic cross-sectional view illustrating a light detector according to the first embodiment.

The first semiconductor layer 21 and the shape of the insulating layer 23 of the light detector 109 illustrated in FIG. 12 is different from the light detector 106 illustrated in FIG. 9.

The multiple voids 25 are provided in the light detector 109 as well. The upper surface of the insulating layer 23 includes the multiple oblique surfaces s1. The upper surface of the first semiconductor layer 21 includes the multiple oblique surfaces s3. For example, the thickness of the insulating layer 23 is constant.

In the manufacturing processes of the SOI substrate 20, the SOI substrate 20 of FIG. 12 is realized by patterning a portion of the first semiconductor layer 21 used as the support substrate into a shape including oblique surfaces by anisotropic etching and wet etching, forming the insulating layer 23 as a BOX layer by heat treatment, and performing heat treatment to bond with the substrate of the second semiconductor layer 22 used as an active layer. In FIG. 12, the void 25 is formed between the insulating layer 23 and the second semiconductor layer 22; and the structure of the light-receiving element 10 from the second semiconductor layer 22 to the first semiconductor layer 21 is the second semiconductor layer 22, the void 25, the insulating layer 23, and the first semiconductor layer 21 in this order, and is Si/Air/SiO₂/Si in order of material.

By patterning a portion of the insulating layer 23 or the first semiconductor layer 21 as in FIGS. 8 to 12, for example, by patterning into a spherical shape, the sensitivity is increased because the perpendicularly incident component of light that easily passes from the second semiconductor layer 22 to the void 25 is reflected and concentrated by the patterned surface toward the photoelectric conversion part 17 as in a concave mirror. By patterning into a shape that includes oblique surfaces, the angle of the light passing from the second semiconductor layer 22 to the void 25 can be changed when reflected, and the sensitivity can be increased.

Although examples using the SOI substrate 20 of various specifications of FIGS. 8 to 12 are described, the light detector is not limited thereto, and includes a light detector that uses the SOI substrate 20 in which the SOI substrate 20, a portion of the insulating layer 23, or a portion of the first semiconductor layer 21 is patterned.

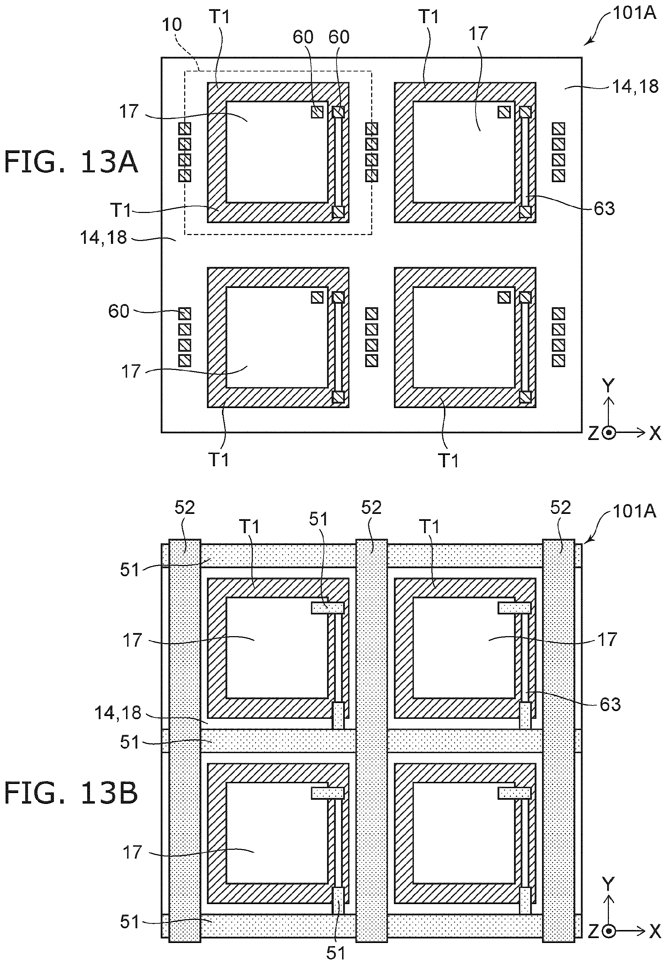

Examples of structures will now be described with reference to FIGS. 13A to 16B. However, the following descriptions related to FIGS. 13A to 16B are examples; and the light detector according to the embodiment is not limited to the description below.

FIGS. 13A and 13B are schematic plan views illustrating a light detector according to the first embodiment.

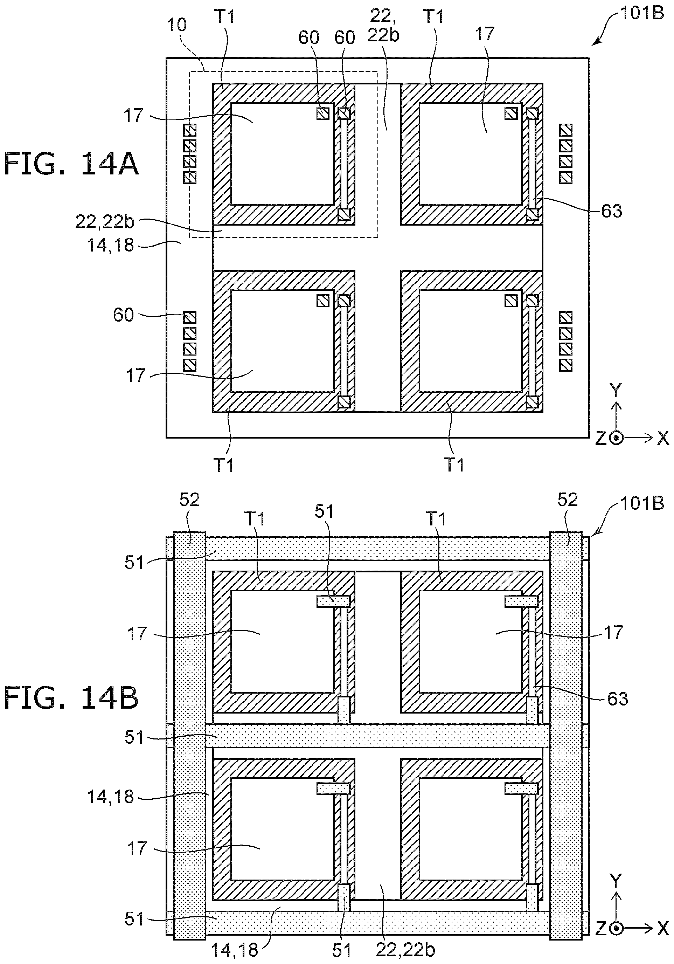

A description similar to that of the light detector 101 is applicable to the light detector 101A illustrated in FIGS. 13A and 13B. However, in the light detector 101A, the second semiconductor layer 22b may not be provided in the bias region 18. FIG. 13B illustrates an area from the second semiconductor layer 22 to the multilevel wiring (the first wiring layer 51 and the second wiring layer 52). This is similar for FIG. 14B, FIG. 15B, FIG. 16B, and FIG. 18B below as well. FIG. 13A illustrates FIG. 13B with the multilevel wiring not illustrated. FIG. 13A illustrates an area from the second semiconductor layer 22 to the contact hole 60. This is similar for FIG. 14A, FIG. 15A, FIG. 16A, and FIG. 18A below as well.

In the example of FIGS. 13A and 13B, the multiple trenches T1 respectively surround the multiple photoelectric conversion parts 17. In other words, one trench T1 surrounds one photoelectric conversion part 17. The multiple trenches T1 are provided independently for each element. The multiple trenches T1 are separated and do not physically contact each other. Compared to when one separation structure is located between the adjacent photoelectric conversion parts 17, the number of the trench T1 interfaces between the adjacent photoelectric conversion parts 17 is increased. By increasing the number of interfaces, the secondary photons that travel toward the adjacent photoelectric conversion parts 17 when secondary photons are generated in the photoelectric conversion part 17 are more easily reflected. The crosstalk noise can be further reduced thereby.

As illustrated in FIG. 13A, the bias region 18 and the fourth semiconductor region 14 surround the multiple photoelectric conversion parts 17. In the example, the fourth semiconductor region 14 is positioned in the bias region 18 between two mutually-adjacent photoelectric conversion parts 17. For example, the fourth semiconductor region 14 extends in the Y-axis direction between the trenches T1 adjacent to each other in the X-axis direction. The fourth semiconductor region 14 extends in the X-axis direction between the trenches T1 adjacent to each other in the Y-axis direction.

For example, the potential can be applied from the upper surface 22f of the second semiconductor layer 22 to the photoelectric conversion part 17 by forming the contact hole 60 to the fourth semiconductor region 14. In the example, the contact holes 60 are formed at two opposite sides among the four sides surrounding the trench T1. As illustrated in FIG. 13B, as long as interference does not occur when considering the layout of the bias signal line and the read signal line made of the first and second wiring layers 51 and 52, for example, three sides or four sides may be used. Conversely, only one side may be used when interference occurs for two sides.

The fourth semiconductor region 14 may contact all sides of the outer perimeter of one trench T1 and all sides of the outer perimeter of another adjacent trench T1 in the X-Y plane.

For example, the planar shape in the X-Y plane of the trench T1 is polygonal ring-shaped. In the example, the trench T1 is quadrilateral when viewed from above. The trench T1 may be octagonal when viewed from above.

According to the embodiment, "ring-shaped" includes not only a circular exterior shape of the planar shape when viewed from above, but also polygonal. The scope of "polygonal" includes polygonal with curved (rounded) corners. In other words, "polygonal" may be a shape that includes multiple sides (straight lines) and curves connecting the sides to each other. The scope of "ring-shaped" may include not only a continuous ring shape without breaks, but also circular or polygonal (e.g., substantially C-shaped) with one or more breaks.

According to the embodiment, "surround" includes not only the case where an unbroken component continuously surrounds another component, but also the case where multiple components are separated from each other and arranged around the other component. For example, the other component can be considered to be surrounded with the multiple components when the other component is positioned inside a trajectory obtained by tracing along the multiple components. The other component can be considered to be surrounded with a circular shape or a polygon when the other component is positioned inside a circular shape or a polygon having one or more breaks when viewed in plan from above.

FIGS. 14A and 14B are schematic plan views illustrating a light detector according to the first embodiment.

The planar shapes of the bias region 18 and the fourth semiconductor region 14 of the light detector 101B illustrated in FIGS. 14A and 14B are different from those of the light detector 101A.

As illustrated in FIG. 14A, the second semiconductor layer 22b also is located in a portion between the trenches T1. For example, the second semiconductor layer 22b can be a region of the epitaxial layer into which an impurity is not ion-implanted.

For example, the bias region 18 and the fourth semiconductor region 14 surround the second semiconductor layer 22b and the multiple photoelectric conversion parts 17. In other words, the second semiconductor layer 22b and the multiple photoelectric conversion parts 17 are surrounded with the inner perimeter surface of the ring-shaped fourth semiconductor region 14 in the X-Y plane.

The fourth semiconductor region 14 surrounds the outer perimeter of the second semiconductor layer 22b and the photoelectric conversion parts 17; and a contact to the fourth semiconductor region 14 is provided. Thereby, the potential can be applied from the upper surface of the second semiconductor layer 22 to the photoelectric conversion part 17. Here, the fourth semiconductor region 14 does not necessarily surround the second semiconductor layer 22b; for example, the second semiconductor layer 22b may surround the fourth semiconductor region 14. The purpose is to apply the potential to the photoelectric conversion part 17 by providing the contact hole 60 on the upper portion of the fourth semiconductor region 14 and ion-implanting the fourth semiconductor region 14 with an impurity concentration such that an ohmic junction is formed with the contact hole 60.

In FIGS. 14A and 14B, the fourth semiconductor region 14 is formed in the region at the outermost perimeter of the multiple light-receiving elements 10 arranged in an array; otherwise, the second semiconductor layer 22 (the second semiconductor layer 22b) exists as-is without the implantation of an impurity between the trenches T1 of the adjacent light-receiving elements 10. The contact hole 60 is formed at a portion of the outermost perimeter in which the fourth semiconductor region 14 is formed and is connected to the bias signal line. Although the contact holes 60 are formed at only one side in FIGS. 14A and 14B, two sides may be used. Although the fourth semiconductor region 14 is formed at only the outermost perimeter, the fourth semiconductor region 14 and the contact hole 60 may be formed in regions other than the outermost perimeter as well. Because the second semiconductor layer 22b partially exists without the fourth semiconductor region 14 completely occupying the region between the trenches T1, for example, an impurity region, diode, etc., can be formed for another purpose.

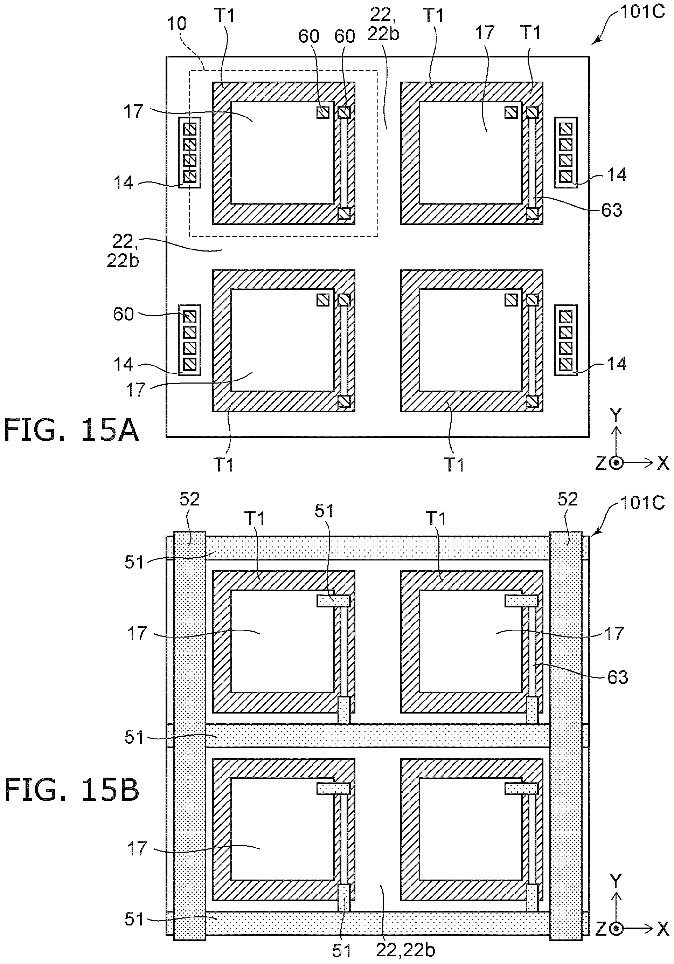

FIGS. 15A and 15B are schematic plan views illustrating a light detector according to the first embodiment.

The planar shapes of the bias region 18, the fourth semiconductor region 14, and the second semiconductor layer 22b of the light detector 101C illustrated in FIGS. 15A and 15B are different from those of the light detector 101B.

The fourth semiconductor region 14 may be located in a portion outside the photoelectric conversion part 17 and the trench T1; and the contact hole 60 may be provided at the fourth semiconductor region 14.

One fourth semiconductor region 14 may be adjacent to one photoelectric conversion part 17. In other words, the fourth semiconductor region 14 and the photoelectric conversion part 17 may correspond one-to-one. Multiple contacts may be provided for one fourth semiconductor region 14. For example, four contacts are arranged as in FIG. 15A.

In FIGS. 15A and 15B, the fourth semiconductor region 14 is formed in a portion between the trenches T1 of the light-receiving elements 10; and the fourth semiconductor region 14 is connected with the bias signal line by forming the contact hole 60. The second semiconductor layer 22 (the second semiconductor layer 22b) exists as-is in the other regions. Although the fourth semiconductor region 14 is formed at only one side in FIGS. 15A and 15B, the fourth semiconductor region 14 may be formed at two to four sides. Similarly to FIGS. 14A and 14B, because the second semiconductor layer 22b partially exists without the fourth semiconductor region 14 completely occupying the region between the trenches T1, for example, an impurity region, diode, etc., can be formed for another purpose. Because the fourth semiconductor region 14 and the photoelectric conversion part 17 correspond one-to-one, the output signals from the light-receiving elements can be separated and extracted by the read signal lines and/or the bias signal lines; and driving with separate driving parameters is possible.

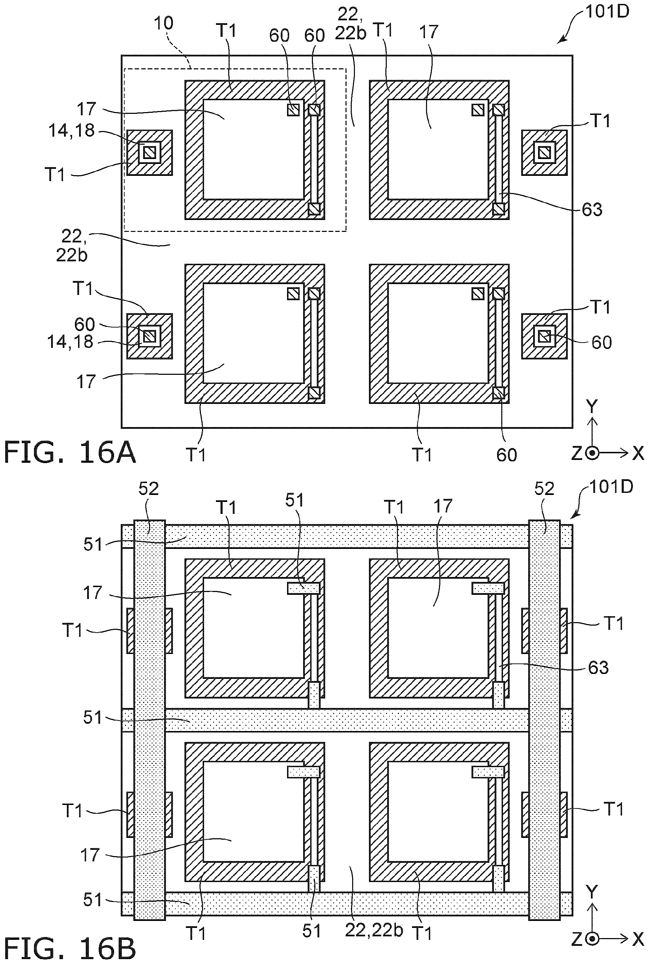

FIGS. 16A and 16B are schematic plan views illustrating a light detector according to the first embodiment.

The planar shapes of the bias region 18, the fourth semiconductor region 14, and the second semiconductor layer 22b of the light detector 101D illustrated in FIGS. 16A and 16B are different from those of the light detector 101C. The light detector 101D further includes multiple ring-shaped trenches T1 that surround the bias region 18.

The multiple trenches T1 respectively surround the multiple bias regions 18. Although the bias region 18 includes the second semiconductor layer 22b and the fourth semiconductor region 14, the semiconductor region 14 may fill the interior of the trench T1 as in the example. Each trench T1 has a ring shape surrounding the bias region 18 in the X-Y plane. The lower end of the trench T1 is positioned on a portion of the third semiconductor region 13 and contacts the portion of the third semiconductor region 13. Thereby, the fourth semiconductor region 14 and the photoelectric conversion part 17 can be electrically connected via a portion of the third semiconductor region 13 under the trench T1.

In the example, one contact is provided for one fourth semiconductor region 14. Multiple contacts may be provided for one fourth semiconductor region 14.

In FIGS. 16A and 16B, a rectangular trench T1 is formed to surround a portion between the trenches T1 of the light-receiving elements 10; the fourth semiconductor region 14 is formed inside the trench T1; and a connection with the bias signal line is made by the contact hole 60. Although one trench T1 and one fourth semiconductor region 14 are formed for one light-receiving element 10 in FIGS. 16A and 16B, multiple trenches and regions may be formed. Although the trench T1 surrounds the fourth semiconductor region 14, the second semiconductor layer 22 also may exist.

By surrounding the bias region 18 with the trench T1, a better one-to-one correspondence with the photoelectric conversion part 17 is possible. By surrounding with the trench T1, the diffusion of an impurity into the region (22b in the drawing) outside the trench T1 can be prevented. Thereby, diodes and the like that have another purpose can be formed at high density in the region outside the trench T1. For similar reasons, the impurity concentration of the fourth semiconductor region 14 can be further increased, and a lower resistance is possible.

Thus, the layouts of the bias region 18, the fourth semiconductor region 14, the second semiconductor layer 22b, and the contact hole 60 are described using FIGS. 13A to 16B. These layouts are not limited to the descriptions; for example, as shown in FIG. 3, a configuration in which the bias region 18 is made of the second semiconductor layer 22b and the fourth semiconductor region 14 may be used. Also, the first wiring layer 51 and the second wiring layer 52 are not limited to these descriptions.

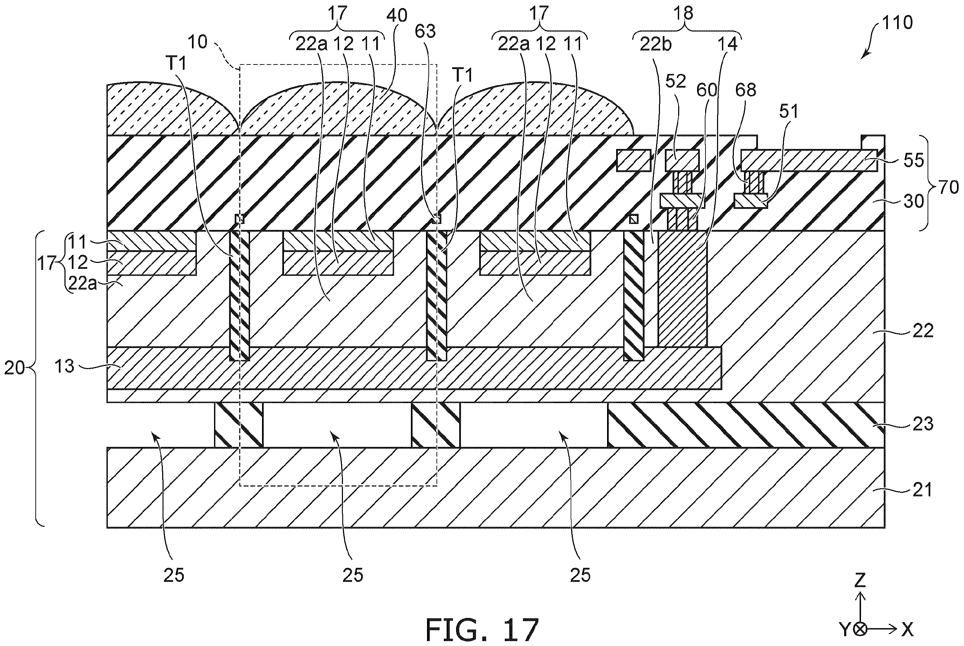

Examples of structures will now be described with reference to FIGS. 17 to 20. However, the following descriptions related to FIGS. 17 to 20 are examples; and the light detector according to the embodiment is not limited to the description below.

FIG. 17 is a schematic cross-sectional view illustrating a light detector according to the first embodiment.

The shapes of the trench T1 and the second semiconductor layer 22 of the light detector 110 illustrated in FIG. 17 are different from those of the light detector 101 illustrated in FIG. 3. In the example, only one trench T1 is located between two mutually-adjacent photoelectric conversion parts 17. For example, two or more trenches T1 are not provided between the photoelectric conversion parts 17. For example, the bias region 18 and the fourth semiconductor region 14 are not provided between the photoelectric conversion parts 17.

In the photoelectric conversion part 17, the first semiconductor region 11 and the second semiconductor region 12 may not contact the trench T1.

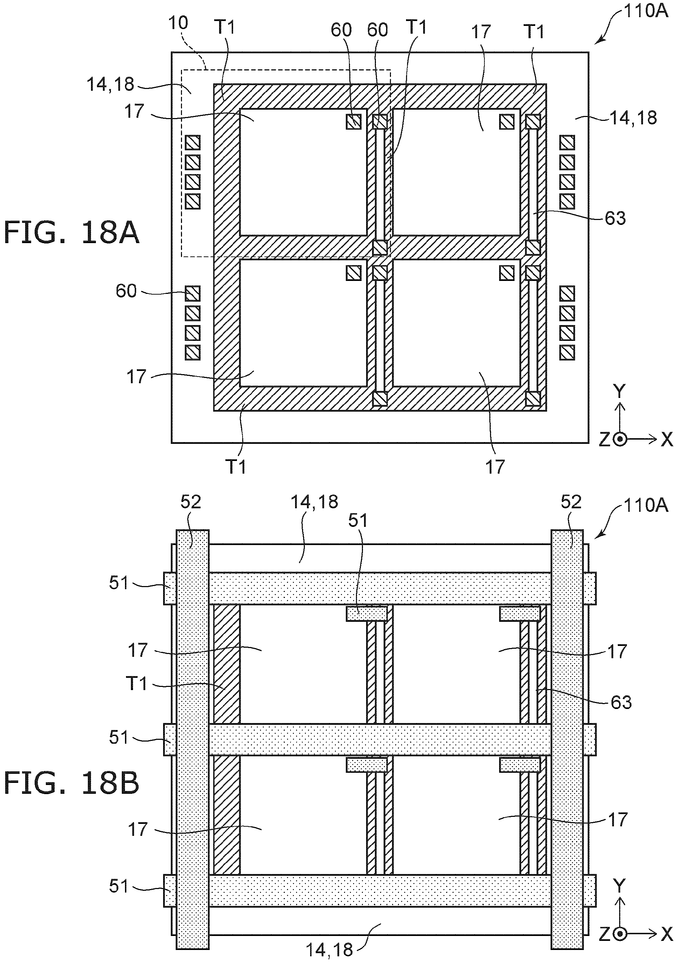

FIGS. 18A and 18B are schematic plan views illustrating a light detector according to the first embodiment.

A trench T1 similar to that of the light detector 110 is included in the light detector 110A illustrated in FIGS. 18A and 18B.

For example, the trench T1 extends in the Y-axis direction between the photoelectric conversion parts 17 adjacent to each other in the X-axis direction. The trench T1 extends in the X-axis direction between the photoelectric conversion parts 17 adjacent to each other in the Y-axis direction.

Thus, as described with reference to FIG. 17 and FIGS. 18A and 18B, one continuous trench T1 may be located between multiple photoelectric conversion parts 17.

By using the light-receiving element 10 having the single-trench structure illustrated in FIG. 17 and FIGS. 18A and 18B, for the same light-receiving element 10 size, the surface area of the photoelectric conversion part 17 can be increased, and the sensitivity increase and/or the output current can be increased. For the same photoelectric conversion part 17 size, the size of the light-receiving element 10 can be reduced, the chip size of the light detector can be reduced, the number of the light-receiving elements 10 that can be arranged can be increased, and characteristic improvement and/or lower costs of the light detector are possible.

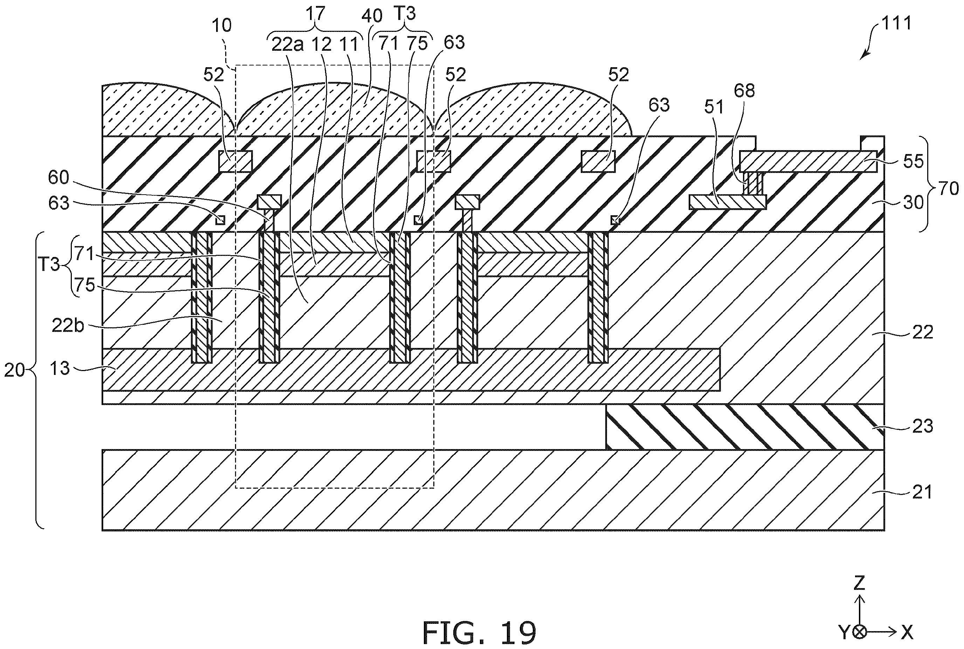

FIG. 19 is a schematic cross-sectional view illustrating a light detector according to the first embodiment.

The configuration of a metal trench T3 of the light detector 111 illustrated in FIG. 19 is different from that of the light detector 101. Specifically, the light detector 111 further includes an insulating part 71 and a conductive part 75 located inside the metal trench T3. The bias region 18 and the fourth semiconductor region 14 may not be included in the light detector 111.

The side surface of the conductive part 75 is covered with the insulating part 71. The conductive part 75 extends in the Z-axis direction from the upper surface 22f of the second semiconductor layer 22 to a portion of the third semiconductor region 13 inside the metal trench T3. The conductive part 75 is electrically connected to the third semiconductor region 13. Specifically, the lower end of the conductive part 75 contacts the portion of the third semiconductor region 13. The upper end of the conductive part 75 is connected to the bias signal line via the contact hole 60. Thereby, the first electrode pad 55 and the photoelectric conversion part 17 can be the electrically connected via the conductive part 75 and a portion of the third semiconductor region 13 under the metal trench T3. Even when the fourth semiconductor region 14 is not included, the voltage can be applied from the upper surface 22f side of the second semiconductor layer 22 to the photoelectric conversion part 17. For example, by providing the conductive part 75, the electrical resistance from the contact hole 60 to the photoelectric conversion part 17 can be reduced. The conductive part 75 includes, for example, at least one metal selected from the group consisting of titanium, tungsten, copper, gold, aluminum, indium, and tin.

Unlike the examples up to this point, a lower power consumption is possible because the bias voltage is applied to the third semiconductor region 13 by the conductive part 75 that is made from a metal and has a low resistance value. Because the conductive part 75 is covered with the insulating part 71, for example, the conductive part 75 is insulated from the second semiconductor layers 22 and 22b adjacent to the metal trench T3. Therefore, for example, the distance between the metal trenches T3 can be reduced, and characteristic improvement and/or lower costs of the light detector are possible similarly to the light detector 110 of FIG. 17. By combining the metal trench T3 with the light-receiving element 10 structure of the embodiment, compared to the trench T1 filled with an insulating film, there are expectations for reduced crosstalk and sensitivity improvement due to optical confinement effect as well.

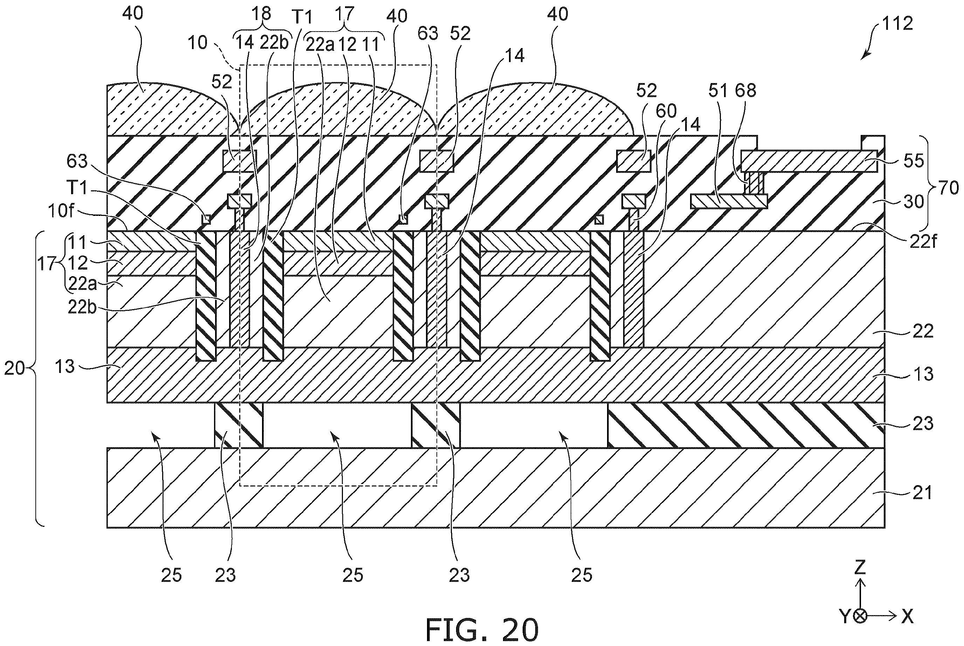

FIG. 20 is a schematic cross-sectional view illustrating a light detector according to the first embodiment.

The location of the third semiconductor region 13 of the light detector 112 illustrated in FIG. 20 is different from that of the light detector 101. In the example, the third semiconductor region 13 extends below the first electrode pad 55. For example, the third semiconductor region 13 is provided over the entire area of the X-Y plane in which the second semiconductor layer 22 is provided.

For example, such a third semiconductor region 13 can be formed by implanting an impurity into the entire wafer surface. Or, a high-concentration substrate that is used to form the third semiconductor region 13 may be bonded on the insulating layer 23. The second semiconductor layer 22 is formed by forming an epitaxial layer on the high-concentration substrate. Or, the third semiconductor region 13 may be formed by doping an impurity when growing an epitaxial layer used to form the second semiconductor layer 22 on the insulating layer 23. Compared to the light detector 101, the impurity concentration, the depth distribution, and the like of the third semiconductor region 13 can be more easily controlled thereby.

It is unnecessary to form the third semiconductor region 13 by impurity implantation to a deep region of the second semiconductor layer 22. For example, it is difficult to form the third semiconductor region 13 by impurity implantation when the thickness of the second semiconductor layer 22 is extremely thick. On the other hand, the configuration of the light detector 112 can be realized regardless of the thickness of the second semiconductor layer 22. In other words, by using the configuration of the light detector 112, the second semiconductor layer 22 can be thick, and as a result, the depletion layer thickness of the photoelectric conversion part 17 of the light-receiving element 10 can be increased, and there are expectations for sensitivity improvement.

Although the trench structure (T1 and T3) and the configuration of the SOI substrate 20 are described using FIGS. 17 to 20, the trench structure and/or the substrate configuration shown in the light detectors 110 to 112 and the shape and/or location of the void 25 of the light detectors 101 to 109 may have different combinations of configurations.

An example of a method for manufacturing the light detector 101 will now be described.

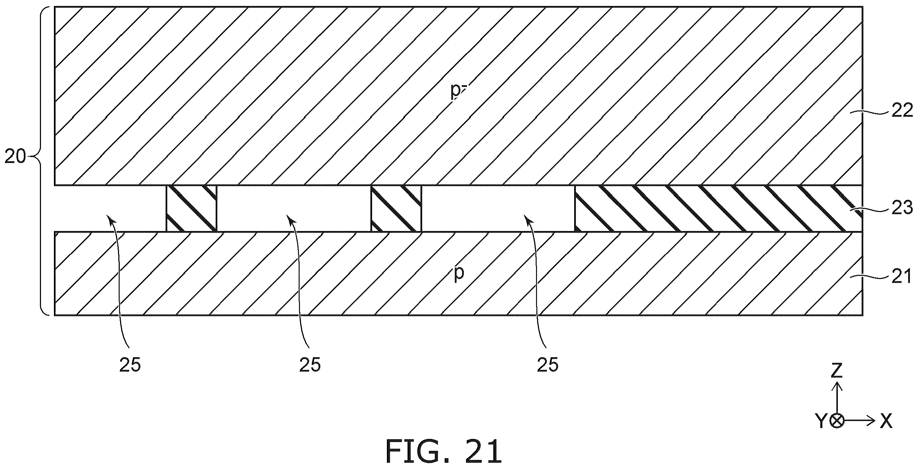

FIGS. 21 to 25 are schematic cross-sectional views in order of the processes, illustrating the method for manufacturing the light detector according to the first embodiment.

As illustrated in FIG. 21, the SOI substrate 20 in which the void 25 is formed is prepared by patterning the insulating layer 23 as a BOX layer. The SOI substrate 20 has a structure in which the first semiconductor layer 21 used as a support substrate, the insulating layer 23, and the second semiconductor layer 22 used as an active layer are stacked in this order; and the void 25 is formed between the first semiconductor layer 21 and the second semiconductor layer 22 in the manufacturing processes of the SOI substrate 20 by etching the insulating layer 23, bonding by heat treatment, etc. The first semiconductor layer 21 and the second semiconductor layer 22 are p-type semiconductors; and the second semiconductor layer 22 is a low-concentration epitaxial layer (p-) formed by epitaxial growth.

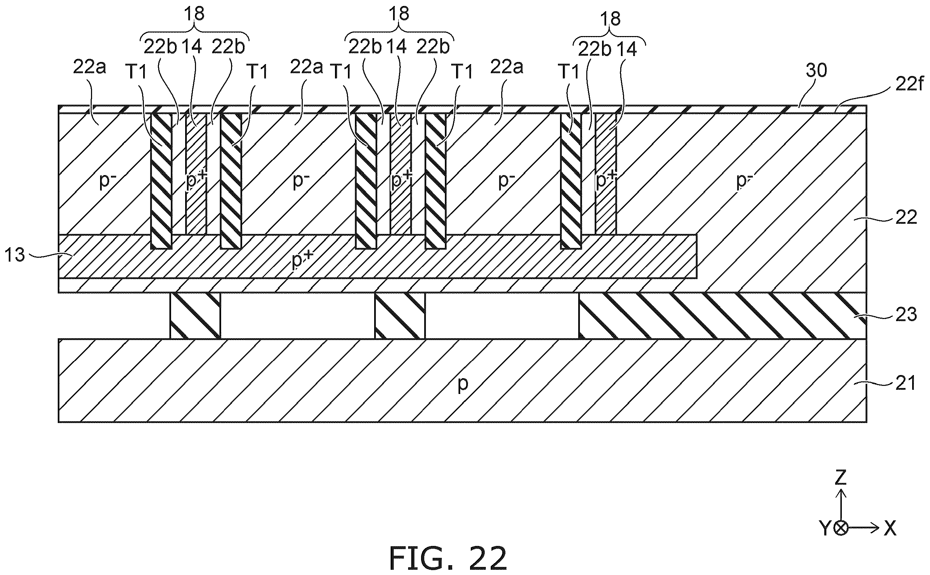

Then, as illustrated in FIG. 22, reactive ion etching or the like is used to form the deep rectangular trench T1 with a high aspect ratio in the second semiconductor layer 22. The trench T1 is an element separation structure of the light-receiving element 10 and performs the role of separating the adjacent light-receiving elements 10 and the peripheral region. For example, the trench T1 is formed by utilizing near-infrared light to align with the void 25 of the SOI substrate 20 and by forming the trench T1 to be aligned with the arrangement pattern of the void 25. The bottom portion of the trench T1 does not extend to the insulating layer 23 but stops inside the second semiconductor layer 22; subsequently, the trench T1 interior is filled with an insulating material by performing sidewall oxidation by heat treatment, filling with an insulating film such as an oxide film, etc. Subsequently, the third semiconductor region 13 is formed as a p⁺-semiconductor layer in the lower region of the light-receiving element 10 by implanting a p-type impurity such as boron or the like with conditions of a MeV-order high acceleration voltage and high concentration. Then, the fourth semiconductor region 14 (p⁺) that has a lattice-shaped pattern is formed, for example, between the trenches T1 by implanting a p-type impurity with a high concentration into the second semiconductor layer 22b in the region outside the rectangular trench T1 (the seam area between the light-receiving elements). That is, the region outside the trenches T1 of the light-receiving elements 10 is used to form the bias region 18 that includes the second semiconductor layer 22b and the fourth semiconductor region 14 formed by impurity implantation into the second semiconductor layer 22b. The insulating layer 30 such as a thermal oxide films or the like is deposited on the upper surface 22f of the second semiconductor layer 22 by subsequent heat treatment, etc.

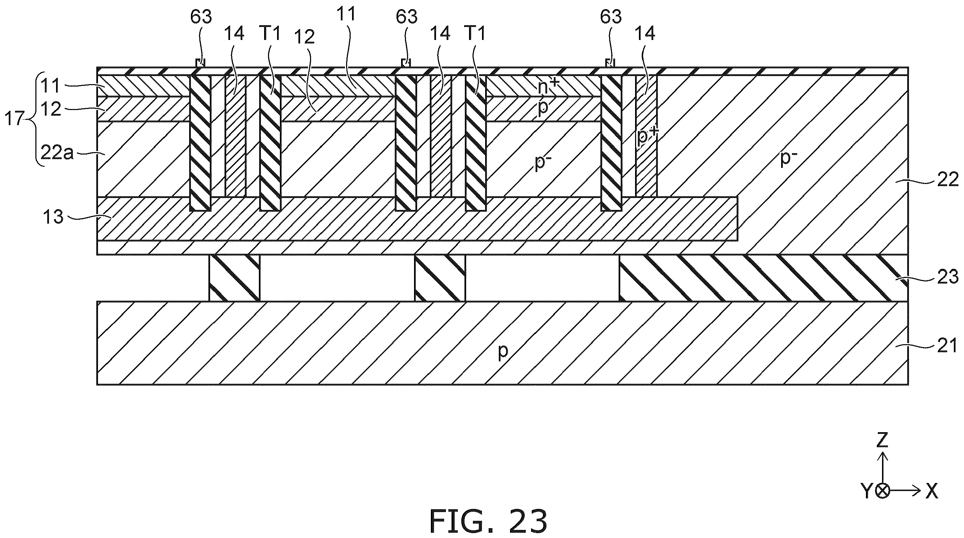

Then, as illustrated in FIG. 23, the quenching part 63 that has high resistance is formed on the deposited insulating layer 30 by, for example, depositing polysilicon doped with an impurity and patterning the polysilicon. Subsequently, in the region (the second semiconductor layer 22a) of the light-receiving element 10 surrounded with the rectangular trench T1, the second semiconductor region 12 is formed by implanting a p-type impurity; and the first semiconductor region 11 is formed by implanting an n-type impurity. At this time, the second semiconductor layer 22a inside the trench T1 of the light-receiving element 10 forms a n⁺/p/p⁻/p⁺ reach-through photodiode from the front side.

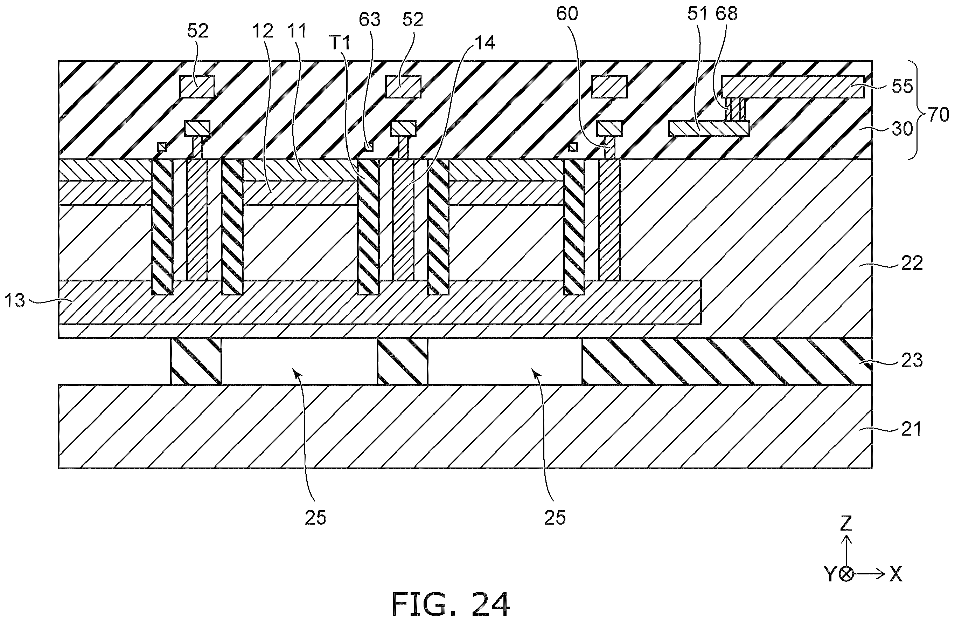

Then, as illustrated in FIG. 24, several layers are made by repeatedly performing the deposition and planarization of the insulating layer 30, the formation of holes (e.g., the contact holes 60) for conduction, and the formation and patterning of metal films. Specifically, after forming the quenching part 63, the insulating layer 30 is deposited, and planarization is performed by, for example, CMP (Chemical Mechanical Polishing), etc. Subsequently, the contact holes 60 are formed on the first semiconductor region 11, i.e., the photodiode part of the light-receiving element 10, on the quenching part 63, and on the fourth semiconductor region 14 and are filled with, for example, a conductive material such as tungsten, etc. Then, the first wiring layer 51, i.e., a metal film of, for example, Al, Cu, or the like is formed and patterned. Then, similar processes are used to pattern the interlayer interconnect 68 and the second wiring layer 52, and while not illustrated in the drawings, the quenching part 63 is connected in series via the first wiring layer 51 and the contact hole 60 from the first semiconductor region 11; and the other end of the quenching part 63 is connected to the first wiring layer 51 via the contact hole 60. The first wiring layers 51 of the light-receiving elements 10 are connected in parallel and connected to the first electrode pad 55 via the interlayer interconnects 68 and the second wiring layers 52 as necessary. Simultaneously, a contact hole is formed on the fourth semiconductor region 14 and connected to a different pad from the first electrode pad 55 described above (e.g., the not-illustrated second electrode pad 56) via the first wiring layer 51, and as necessary, via the interlayer interconnect 68 and the second wiring layer 52. Of course, the pads and the signal lines are insulated and electrically isolated from each other.

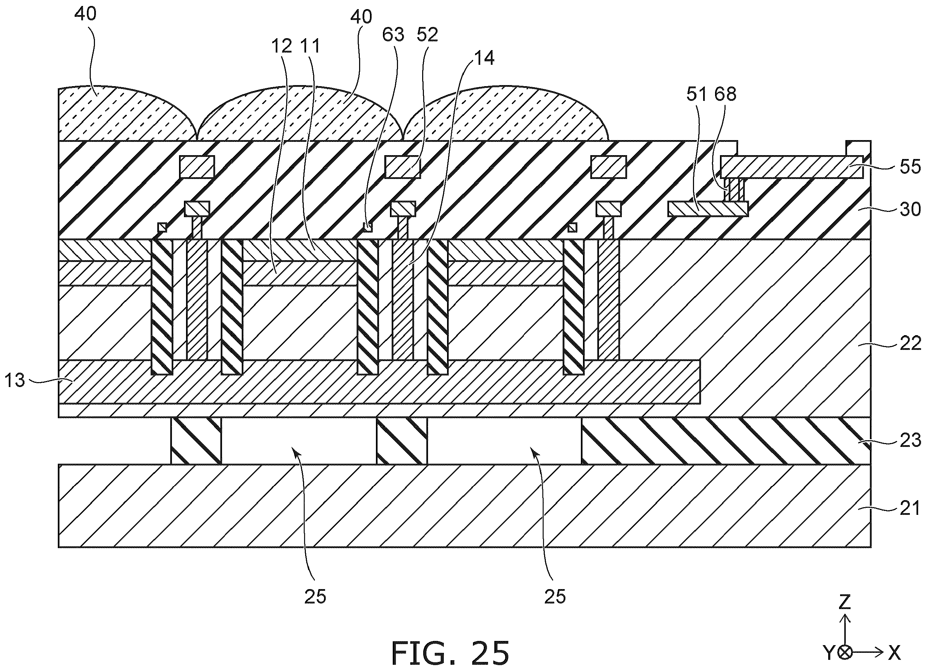

Continuing as illustrated in FIG. 25, the upper surface metal portion of the first electrode pad 55 is exposed by removing the insulating layer 30 above the first electrode pad 55 of the second wiring layer 52. Subsequently, the light concentrator 40 such as, for example, a microlens is formed above the light-receiving element 10 by, for example, coating a photosensitive resist, exposing and developing into the desired mask pattern, and performing reflow processing.

Thus, the light detector described according to the manufacturing method of the embodiment can be manufactured using only general semiconductor processes using an SOI substrate in which a void is provided in a substrate interior, and can be realized without the need of a special post process, etc. For example, when modifying necessary characteristics or the wavelength of the light to be detected, characteristic improvement and optimization adjustments are possible by modifying only the specifications of the SOI substrate; and there are expectations for improving the development speed compared to a conventional impurity profile modification. Lower costs are expected because the mass production line can accommodate many product lines by performing only a substrate specification modification. As a secondary effect of the characteristics of the light detector, in the case of a general silicon substrate, the carriers due to photoelectric conversion in a deep region diffuse and generate an output signal that lags behind the output signal caused by the other carriers. This causes, for example, a crucial error signal in a LiDAR system based on the TOF (Time Of Flight) principle. On the other hand, in the light detector of the embodiment, the carriers that are generated by photoelectric conversion at the support substrate in the deep region are insulated from the photoelectric conversion part by the void or the BOX layer and therefore do not generate an output signal. In other words, the detector of the embodiment not only improves the sensitivity but also drastically improves the S/N by removing output signals that form an error component of the detected output signal.

The structures and the manufacturing method of the embodiment described above are merely examples of the embodiment, and are not limited to these examples as there are structures and/or processes not illustrated in the drawings and descriptions.

### Second embodiment

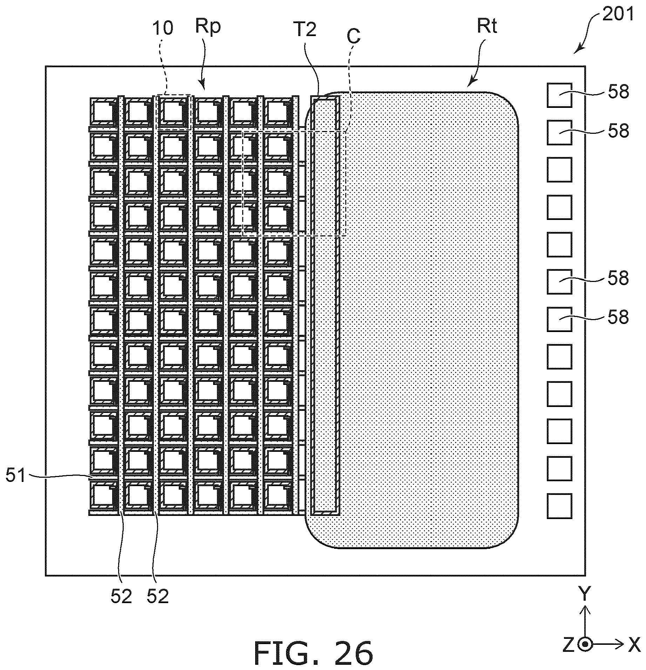

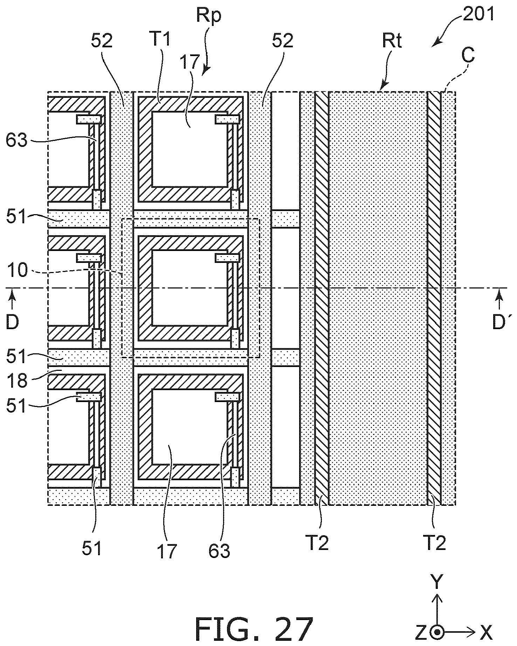

FIGS. 26 and 27 are schematic plan views illustrating a light detector according to a second embodiment.

FIG. 27 illustrates an enlarged region C illustrated in FIG. 26. As illustrated in FIGS. 26 and 27, the light detector 201 according to the embodiment includes a light-receiving region Rp that includes not less than one light-receiving element 10, and a transistor region Rt in which an integrated circuit of a read circuit or the like is located. For example, similarly to the light detector 101, the multiple light-receiving elements 10 are arranged in an array configuration in the light-receiving region Rp. As illustrated in FIG. 27, the light-receiving element 10 includes the trench T1 formed in a rectangular pattern, the photoelectric conversion part 17 surrounded with the trench T1, and the quenching part 63. Although not illustrated in the drawings, the photoelectric conversion part 17 and the quenching part 63 are electrically connected in series via contact holes and the first wiring layer 51. A trench T2 is provided in the transistor region Rt to surround the region in which transistors are formed.

The multiple light-receiving elements 10 are periodically arranged in a two-dimensional array configuration; and the quenching parts 63 are electrically connected in parallel via contact holes by the first wiring layer 51 at the sides not connected with the photoelectric conversion parts 17. The wiring parts that are connected in parallel are connected to the integrated circuit located in the transistor region Rt via interlayer interconnects and the second wiring layer 52. Similarly, the bias region 18 in the trench peripheral part of the light-receiving element 10 is connected to the integrated circuit located in the transistor region Rt via contact holes, the first wiring layer 51, interlayer interconnects, and the second wiring layer 52. Although not illustrated in the drawings, the integrated circuit is wired, and portions of the integrated circuit are connected respectively to electrode pads 58. The light detector 201 performs the desired operations by applying the desired voltage signals to the electrode pads 58. The first wiring layer 51 and the second wiring layer 52 are not limited to the layout shown in FIG. 27, and are intended to have different wiring patterns as necessary to apply the anode potential and the cathode potential to the light-receiving elements 10. Although not illustrated in the drawings, the purpose may be achieved by using third and fourth wiring layers, etc., as necessary.

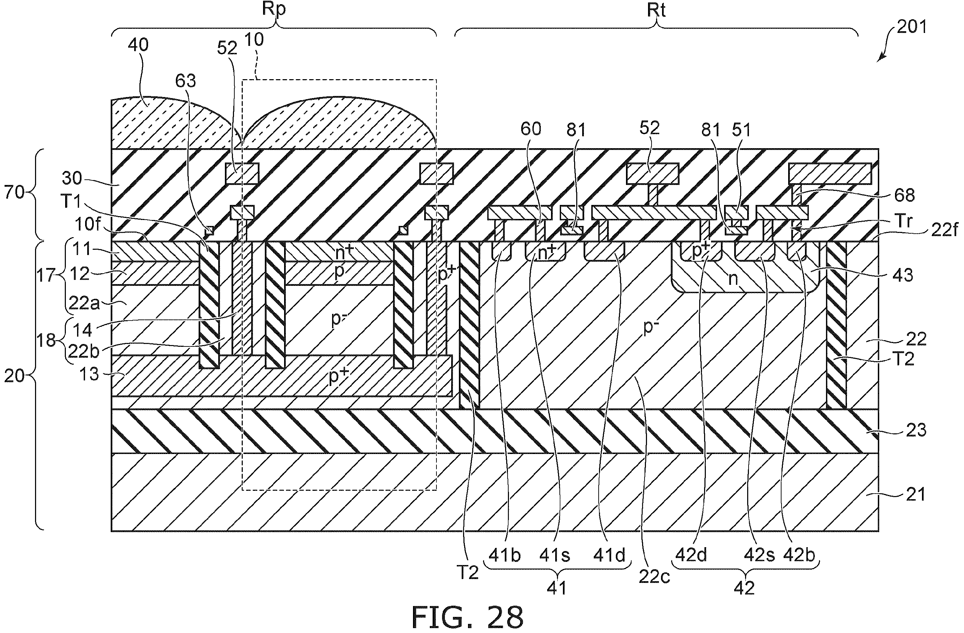

FIG. 28 is a schematic cross-sectional view illustrating the light detector according to the second embodiment.

FIG. 28 illustrates a cross section along line D-D' illustrated in FIG. 27.

The light detector 201 according to the second embodiment is provided in the SOI (Silicon On Insulator) substrate 20 that includes the first semiconductor layer 21 as a support substrate, the second semiconductor layer 22 as an active layer, and the insulating layer 23 as a BOX layer. The light detector 201 includes the light-receiving region Rp that receives light and converts the light into an electrical signal, and the transistor region Rt in which an integrated circuit that supplies voltages to the light-receiving region Rp and processes the generated electrical signals is mounted. The light-receiving element 10 is located in the light-receiving region Rp; and the light-receiving element 10 includes the trench T1 that is formed in a rectangular shape and performs electrical separation from the adjacent light-receiving elements 10, the photoelectric conversion part 17 such as, for example, a vertical photodiode in which an electric field is applied in the vertical direction located in the region surrounded with the trench T1, the multilevel wiring part 70 that applies the desired voltage to the photoelectric conversion part 17, the quenching part 63 connected in series between the multilevel wiring part 70 and the photoelectric conversion part 17, the third semiconductor region 13 that applies a potential from the backside of the photoelectric conversion part 17 and into which a high-concentration impurity is implanted, the bias region 18 that is formed outward of the trench T1 to apply a potential to the third semiconductor region 13, and the light concentrator 40 that concentrates the light incident from the outside on the photoelectric conversion part 17. The photoelectric conversion part 17 includes, for example, the first semiconductor region 11 of the first conductivity type, and the second semiconductor region 12 and the second semiconductor layer 22a of the second conductivity type. The bias region 18 includes, for example, the fourth semiconductor region 14 and the second semiconductor layer 22b of the second conductivity type.

An integrated circuit made of a group of, for example, CMOS (Complementary Metal Oxide Semiconductor) logic ICs is located in the transistor region Rt; and a trench T2 is formed to extend to the insulating layer 23 for element separation. An n-channel MOS (an NMOS 41) and a p-channel MOS (a PMOS 42) are formed in the element-separated region. The multilevel wiring part 70 is a stacked structure on a silicon substrate formed by metal wiring processes of a general semiconductor process, and in FIG. 28, includes the insulating layer 30, the quenching part 63, a gate electrode 81, the contact hole 60, the first wiring layer 51, the interlayer interconnects 68, and the second wiring layer 52.

The trench T1 is formed to the lower region to which the depletion layer of the photoelectric conversion part 17 spreads; and the bottom portion of the trench T1 stops inside the second semiconductor layer 22 and does not extend to the insulating layer 23. In other words, the second semiconductor layer 22 or the third semiconductor region 13 is under the bottom portion of the trench T1. On the other hand, the trench T2 extends to the insulating layer 23. The interiors of the trenches T2 each are filled with insulating films. Although not illustrated in the drawings, an impurity may be implanted to surround the trenches T1 and T2 to repair defects of the bottom portions and/or sidewalls of the trenches T1 and T2.

The photoelectric conversion parts 17 of the light-receiving elements 10 are connected in series to the quenching parts 63 via the contact holes 60 and the first wiring layers 51 at the front surfaces of the first semiconductor regions 11, and are connected in parallel to the read signal line formed of the first wiring layer 51, the interlayer interconnects 68, and the second wiring layer 52 via the contact holes 60 and the first wiring layers 51. For example, the read signal line is connected to the integrated circuit of the transistor region Rt. At the second semiconductor layers 22a of the photoelectric conversion parts 17, for example, the bias signal line made of the first wiring layer 51, the interlayer interconnects, and the second wiring layer 52 connected with the integrated circuit are connected in parallel with the fourth semiconductor regions 14 via the contact holes 60 and the first wiring layers 51; and the fourth semiconductor regions 14 that have a lower resistance are connected to the second semiconductor regions 12 of the photoelectric conversion parts 17 via the third semiconductor regions 13.

The NMOS 41 and the PMOS 42 of the transistor region Rt are connected to the first wiring layer 51 via the contact holes 60; and an integrated circuit that has the desired function is formed by the wiring pattern of the first wiring layer 51, the interlayer interconnects 68, and the second wiring layer 52. The integrated circuit is connected to the light-receiving element 10 and the electrode pad 58 via the first wiring layer 51, the interlayer interconnects 68, and the second wiring layer 52.

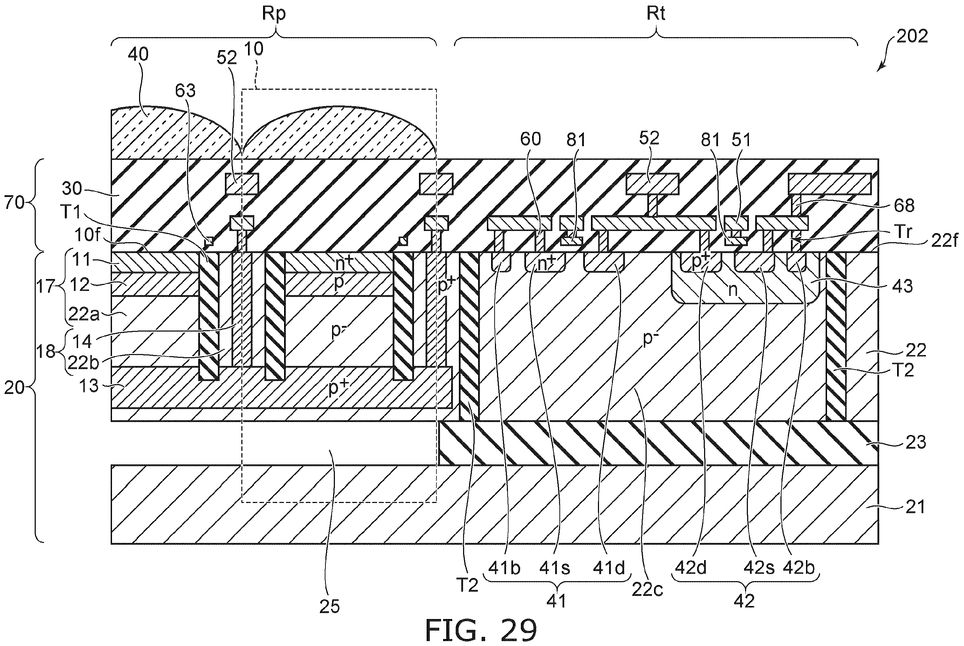

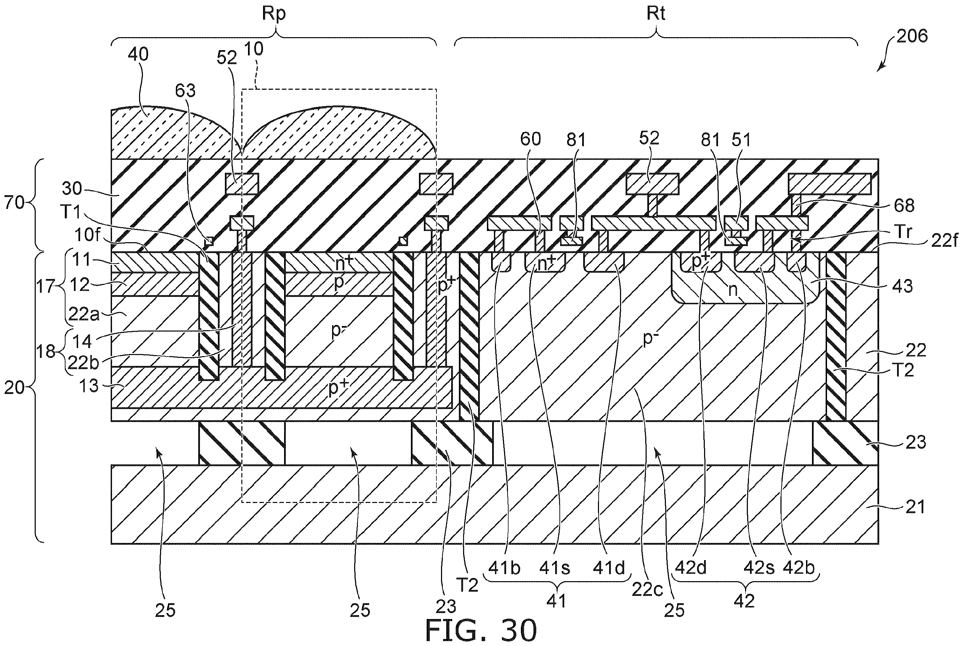

As illustrated in FIG. 29, the light detector may use the SOI substrate 20 that includes the first semiconductor layer 21 as a support substrate, the second semiconductor layer 22 as an active layer, the insulating layer 23 as a BOX layer, and a void 25 formed between the first semiconductor layer 21 and the second semiconductor layer 22 by performing a bonding process after etching a portion of the insulating layer 23 in a substrate manufacturing process. In FIG. 29, the void 25 is formed at a position in the lower portion of the light-receiving region Rp. As in the first embodiment, the sensitivity is improved by providing the void 25 in the lower region of the light-receiving element 10. As illustrated in FIG. 30, the void 25 may be provided in the lower region of the transistor region Rt.

Although the pattern of the first and second semiconductor regions 11 and 12 of the photoelectric conversion part 17 according to the embodiment is formed over the entire surface of the region surrounded with the trench T1, the first semiconductor region 11 and the second semiconductor region 12 are not limited to such a pattern; a region in which the first semiconductor region 11 and the second semiconductor region 12 are not formed, i.e., the second semiconductor layer 22a, may be located between the trenches T1. It is sufficient for the photoelectric conversion part 17 to have, for example, an operational mechanism such as that of a photodiode; and the configuration including the arrangement and conductivity types of the semiconductor regions is arbitrary.

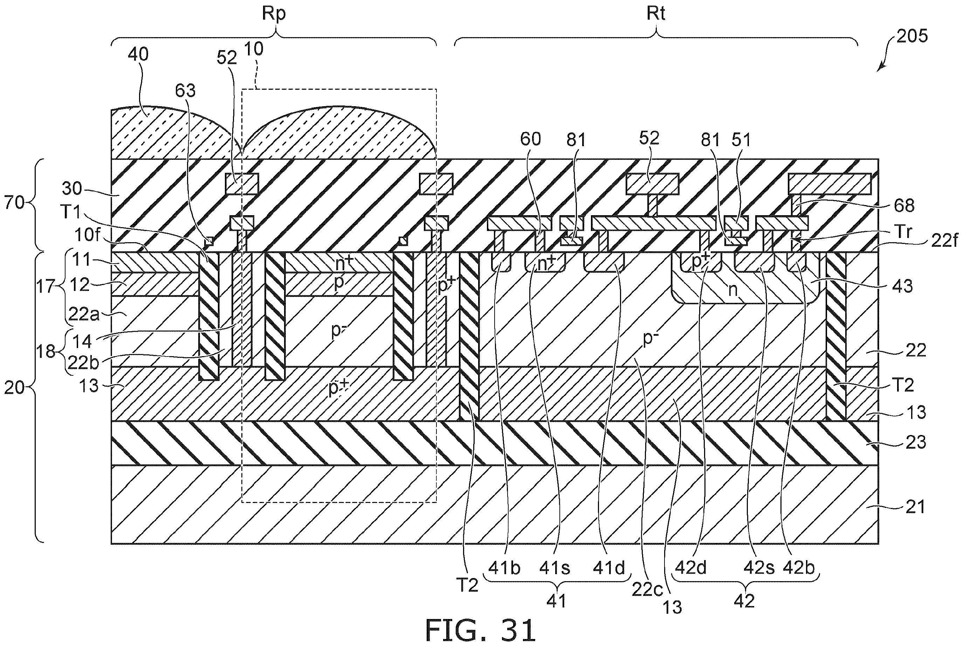

Because the third semiconductor region 13 functions as the bias electrode of the photoelectric conversion part 17, it is favorable for the third semiconductor region 13 to have a high impurity concentration, a large pattern, and a lower resistance. The fourth semiconductor region 14 connects the bias signal from the pad with the same conductivity type as the third semiconductor region 13 to connect to the third semiconductor region 13 without electrical loss. The connection of the third and fourth semiconductor regions 13 and 14 of FIG. 28 is conceptual and is not limited to this cross-sectional structure; for example, a structure in which a region of the same impurity concentration as the second semiconductor layer 22 is located between the third semiconductor region 13 and the fourth semiconductor region 14 also is included in the embodiment. In other words, any region that separates the elements, has a high impurity concentration from the front surface, and is of the same conductivity type as the second semiconductor layer 22 is the fourth semiconductor region 14 and is included in the embodiment as long as the third and fourth semiconductor regions 13 and 14 are not physically separated by an insulating film, etc. As illustrated in FIG. 31, the third semiconductor region 13 may be formed over the entire surface of the lower portion of the second semiconductor layer 22 on the insulating layer 23. For example, such a third semiconductor region 13 can be formed by implanting an impurity into the entire wafer surface. Or, a high-concentration substrate that is used to form the third semiconductor region 13 is bonded on the insulating layer 23; and the second semiconductor layer 22 that has a low concentration is formed by epitaxial growth on the high-concentration substrate. Or, a second semiconductor layer 22 that has a concentration gradient due to impurity doping when forming the active layer by epitaxial growth may be bonded.

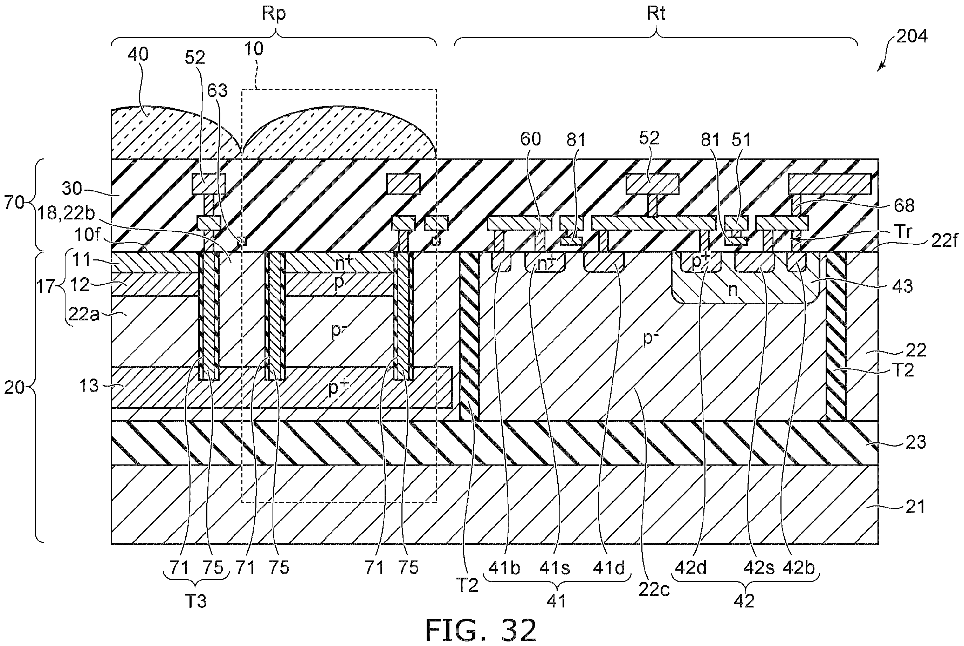

Although the trench T1 of which the interior is filled with an insulating film is described in the examples up to this point, the metal trench T3 may be used as in FIG. 32, in which the trench side wall of the light-receiving element is covered with the insulating part 71, and the interior is filled with the conductive part 75. Because the conductive part 75 is exposed at the bottom portion of the metal trench T3, the bias signal can be applied to the third semiconductor region 13 via the conductive part 75 of the metal trench T3 by forming a contact hole on the conductive part 75 and connecting the bias signal line. Thereby, it is unnecessary to form the fourth semiconductor region 14. Although the bias signal is conducted by the metal trench T3 in FIG. 32, a structure may be used in which the bottom portion also is covered with the insulating part 71, the conductive part 75 and the active layer do not conduct, and the bias signal is applied by forming the fourth semiconductor region 14 between the metal trenches T3. By combining the metal trench T3 with the light-receiving element structure of the embodiment, compared to the trench T1 that is filled with an insulating film, crosstalk is reduced, and the sensitivity is improved by the optical confinement effect.

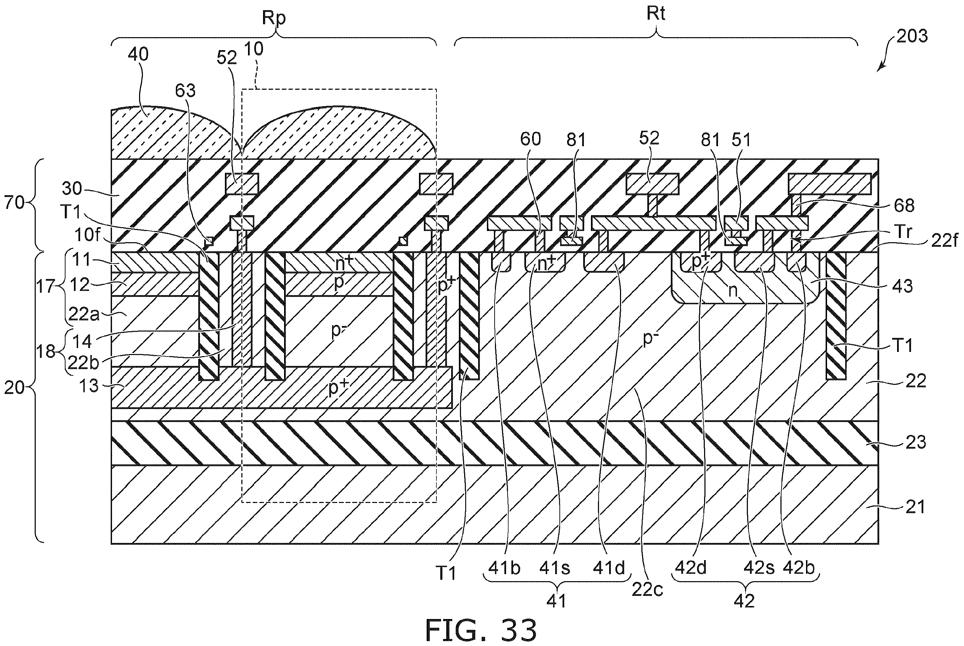

In FIG. 28, the trench depth is different between the trench T1 of the light-receiving region Rp and the trench T2 of the transistor region Rt; and the trench T2 reaches the insulating layer 23. In other words, the trench T1 and the trench T2 are formed in separate processes. On the other hand, as illustrated in FIG. 33, as in the first embodiment, the trench T2 of the transistor region Rt is formed in the same process as the trench T1 of the light-receiving region Rp; and the bottom portion of the trench T2 does not reach the insulating layer 23 and stops inside the second semiconductor layer 22. The third semiconductor region 13 is formed in the lower portion of the light-receiving region Rp; and the second semiconductor layer 22 remains as-is in the lower portion of the transistor region Rt. That is, compared to the lower region of the transistor region Rt, the lower region of the light-receiving region Rp is a low-resistance region into which an impurity is implanted with a high concentration; and the electrical signal from the fourth semiconductor region 14 easily flows toward the light-receiving region Rp side. That is, the charge that is generated in the photoelectric conversion part 17 flows into the integrated circuit via the fourth semiconductor region 14 without flowing into the transistor region.

When the charge is generated and amplified in the photoelectric conversion part 17 and flows through the quenching part 63 as an output current, the quenching part 63 has the mechanism of causing a voltage drop and stopping (quenching) the amplification of the photoelectric conversion part 17. Therefore, the quenching part 63 includes, for example, polysilicon having a high resistance on the order of kS2 to MΩ, but the material is not limited to polysilicon. In FIG. 28, the quenching part 63 is formed between the second semiconductor layer 22 and the first wiring layer 51 on the trench T1, but the arrangement is intended not to shield the light irradiated on the photoelectric conversion part 17; for example, the quenching part 63 may be formed on the photoelectric conversion part 17 in the case where the light concentrator 40 can concentrate the light or when the quenching part 63 is formed of a material having high transmissivity.

The structure of the light-receiving element 10 from the second semiconductor layer 22 to the first semiconductor layer 21 is the second semiconductor layer 22, the insulating layer 23, and the first semiconductor layer 21 in this order, and Si/SiO₂/Si in order of material. Compared to a light detector manufactured using a general silicon substrate, because the insulating layer 23 has a different material, the light that passes through the photoelectric conversion part 17 without being absorbed returns to the photoelectric conversion part as a reflected light component due to the refractive index difference; and the sensitivity is improved. This structure is not limited to the Si/SiO₂/Si of FIG. 28 and is modifiable according to the specifications of the SOI substrate 20. For example, the specifications of the SOI substrate 20 and the configuration of the light-receiving element 10 may be as shown in FIGS. 3 to 5 or FIGS. 8 to 12 according to the first embodiment.

Descriptions of examples of the structure will now be continued with reference to FIGS. 28 to 33. However, the following are examples; and the light detector according to the embodiment is not limited to the description below.

As illustrated in FIG. 28, the insulating layer 23 is located on the first semiconductor layer 21. In the example, the void 25 may not be provided in the first semiconductor layer 21 and the insulating layer 23.

The light-receiving region Rp includes the photoelectric conversion part 17, the third semiconductor region 13, the fourth semiconductor region 14, and the trench T1. The insulating layer 30, the quenching part 63, the first wiring layer 51, the second wiring layer 52, the light concentrator 40, etc., are located in the upper portion of the light-receiving region Rp.

The transistor region Rt is arranged with the light-receiving region Rp in the X-axis direction. In the example, the transistor region Rt is located on the insulating layer 23. The transistor region Rt includes at least a portion of a transistor Tr.

Specifically, as illustrated in FIG. 28, the transistor region Rt includes the NMOS 41 and the PMOS 42, i.e., a portion of the transistor Tr, and the trench T2 that provides electrical isolation from the light-receiving region.

The trench T2 is provided in the second semiconductor layer 22. At least a portion of the trench T2 is positioned between the transistor region Rt and the light-receiving region Rp. The trench T2 surrounds the side surface of the transistor region Rt. For example, the trench T2 has a ring shape contacting the entire outer perimeter of the transistor region Rt in the X-Y plane (when viewed along the Z-axis direction). For example, in the X-Y plane, the trench T2 has a substantially rectangular shape continuously surrounding the outer perimeter of the transistor region Rt.

The trench T2 includes an insulating material. For example, the trench T2 includes silicon and one selected from the group consisting of oxygen and nitrogen. For example, the trench T2 includes silicon oxide or silicon nitride. The trench T2 may have a stacked structure.

For example, a light detector of a reference example does not include the insulating layer 23. In the light detector of the reference example, a semiconductor layer (e.g., the second semiconductor layer) is located directly on the semiconductor substrate; and the light-receiving region and the transistor region are located in the semiconductor layer. In the light detector of the reference example, for example, a back electrode is located under the semiconductor substrate. A voltage is applied to the photoelectric conversion part by the back electrode. In such a case, for example, the voltage of the back electrode also is applied to the transistor region; and there is a risk that the operations of CMOS (Complementary Metal Oxide Semiconductor) or other circuits in the transistor region may become unstable. For example, the width of the depletion layer of the photoelectric conversion part increases as the drive voltage of the light-receiving element, i.e., the voltage applied to the photoelectric conversion part by the back electrode, increases. The sensitivity of the photoelectric conversion part can be increased thereby. However, the high-potential driving of the back electrode increases the effects of the substrate bias; and it is considered that the circuit operations of the transistor circuit part may become unstable. For example, it also may be considered to increase the sensitivity by increasing the depletion layer width by forming the photodiode to be wide in the depth direction. However, there are cases where the formable depth of the photodiode is limited by the process limits of ion implantation and trench patterning. Thus, in the reference example, there are cases where it is difficult to improve the sensitivity by increasing the depletion layer width from the perspective of the circuit operation stability and the manufacturing process.

In contrast, according to the embodiment, the photoelectric conversion part 17 is positioned above the insulating layer 23. Similarly to the light detector according to the first embodiment, the sensitivity can be increased thereby. The light-receiving region Rp includes the third semiconductor region 13 that includes a portion located between the insulating layer 23 and the photoelectric conversion part 17. The trench T1 is located on the third semiconductor region 13. Thereby, the voltage can be applied from the upper surface 22f side of the second semiconductor layer 22 to the photoelectric conversion part 17 via the third semiconductor region 13 below the trench T1. Also, the trench T2 is located between the transistor region Rt and the light-receiving region Rp. In other words, the trench T2 separates the transistor region Rt from the light-receiving region Rp. The effects of the voltage applied to the photoelectric conversion part 17 on the transistor region can be suppressed thereby. The instability of the circuit operations of the transistor circuit part can be suppressed.

For example, the trench T2 is deeper than the trench T1. In other words, the lower end of the trench T2 is positioned lower than the lower end of the trench T1. In the example of FIG. 28, the lower end of the trench T2 reaches the insulating layer 23. The trench T2 extends from the upper surface 22f of the second semiconductor layer 22 to the insulating layer 23. In other words, the trench T2 extends through the second semiconductor layer 22. The instability of the circuit operations of the transistor circuit part can be further suppressed thereby. For example, the transistor region Rt is electrically isolated from the light-receiving region Rp because the transistor region Rt is surrounded with the trench T2 and the insulating layer 23.

FIG. 29 is a schematic cross-sectional view illustrating a light detector according to the second embodiment.

The configurations of the insulating layer 23 and the void 25 of the light detector 202 illustrated in FIG. 29 are different from those of the light detector 201 illustrated in FIG. 28.

In the example as illustrated in FIG. 29, the SOI substrate 20 includes the insulating layer 23 and the void 25. The transistor region Rt is located above the insulating layer 23. The void 25 is located below the light-receiving region Rp. In other words, the photoelectric conversion part 17 is positioned above the void 25. The void 25 is positioned between the photoelectric conversion part 17 and a portion of the first semiconductor layer 21.

Thus, in a transistor-embedded light detector as well, at least one of the first semiconductor layer 21 or the insulating layer 23 may include the void 25. The photoelectric conversion part 17 is positioned above the void 25. The sensitivity can be further improved thereby.

FIG. 30 is a schematic cross-sectional view illustrating a light detector according to the second embodiment.

The configurations of the insulating layer 23 and the void 25 of the light detector 206 illustrated in FIG. 30 are different from those of the light detector 201 illustrated in FIG. 28. The void 25 extends through the insulating layer 23. The void 25 is positioned between the first semiconductor layer 21 and the transistor region Rt. The void 25 is positioned between the first semiconductor layer 21 and the light-receiving region Rp. The NMOS 41 and the PMOS 42 are positioned above the void 25. The photoelectric conversion part 17 is positioned above the void 25.

Thus, according to the embodiment, the transistor region Rt and the light-receiving region Rp can be electrically isolated.

FIG. 31 is a schematic cross-sectional view illustrating a light detector according to the second embodiment.

The location of the third semiconductor region 13 of the light detector 205 illustrated in FIG. 31 is different from that of the light detector 201 illustrated in FIG. 28. For example, the third semiconductor region 13 is provided over the entire area in the X-Y plane in which the second semiconductor layer 22 is provided.

More specifically, the third semiconductor region 13 is located in the transistor region Rt. The third semiconductor region 13 is surrounded with the trench T2 and may include a portion that contacts the trench T2. The NMOS 41 and the PMOS 42 are positioned above the third semiconductor region 13.

For example, the third semiconductor region 13 may be separated by the trench T2 to be discontinuous from the portion of the third semiconductor region 13 located in the light-receiving region Rp.

For example, such a third semiconductor region 13 can be formed by implanting an impurity into the entire wafer surface. Or, a high-concentration substrate that is used to form the third semiconductor region 13 may be bonded on the insulating layer 23. The second semiconductor layer 22 is formed by forming an epitaxial layer on the high-concentration substrate. Or, the third semiconductor region 13 may be formed by doping an impurity when growing an epitaxial layer used to form the second semiconductor layer 22 on the insulating layer 23.

FIG. 32 is a schematic cross-sectional view illustrating a light detector according to the second embodiment.

The configuration of the trench T3 of the light detector 204 illustrated in FIG. 32 is different from that of the light detector 201 illustrated in FIG. 28.

Specifically, in the light detector 204, the insulating part 71 and the conductive part 75 are located inside the trench T3 similarly to the light detector 111 described with reference to FIG. 19. The conductive part 75 is electrically connected to the third semiconductor region 13. Thereby, the second wiring layer 52 and the photoelectric conversion part 17 can be electrically connected via the conductive part 75 and a portion of the third semiconductor region 13 under the trench T3.

FIG. 33 is a schematic cross-sectional view illustrating a light detector according to the second embodiment.

The shape of the trench T1 of the transistor region Rt of the light detector 203 illustrated in FIG. 33 is different from that of the light detector 201 illustrated in FIG. 28.

In the example as illustrated in FIG. 33, the trench T1 of the transistor region Rt has the same structure as the trench T1 of the light-receiving region Rp and therefore does not extend through the second semiconductor layer 22.

The impurity concentration of a second semiconductor layer 22c of the transistor region Rt is less than the impurity concentration of the third semiconductor region 13; and the resistivity Ω·cm (ohm-centimeter) of the second semiconductor layer 22c is greater than the resistivity of the third semiconductor region 13. The effects of charge flowing into the transistor region Rt from the light-receiving region Rp can be reduced thereby. The instability of the circuit operations of the transistor circuit part can be suppressed.

An example of a method for manufacturing the light detector 201 will now be described.

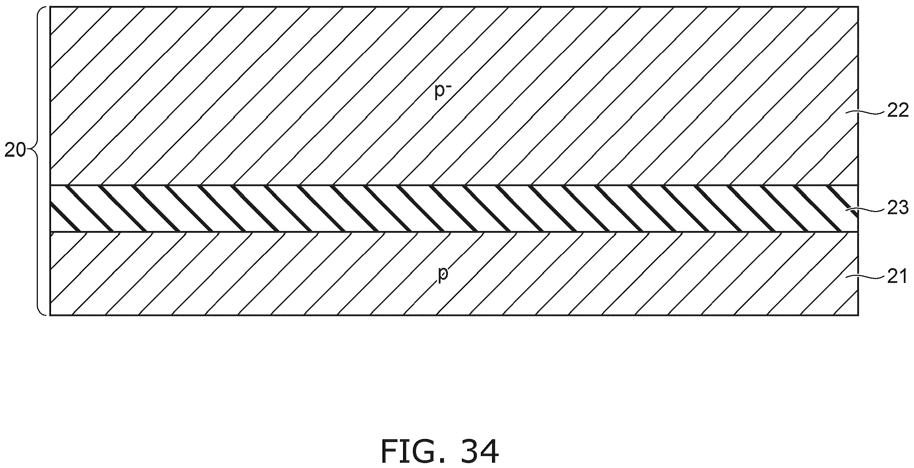

FIGS. 34 to 38 are schematic cross-sectional views in order of the processes, illustrating the method for manufacturing the light detector according to the second embodiment.

As illustrated in FIG. 34, the SOI substrate 20 that includes the first semiconductor layer 21 as a support substrate, the insulating layer 23 as a BOX layer, and the second semiconductor layer 22 as an active layer is prepared. The SOI substrate 20 has a structure in which the first semiconductor layer 21, the insulating layer 23, and the second semiconductor layer 22 are stacked in this order, the first semiconductor layer 21 and the second semiconductor layer 22 are p-type semiconductors, and the second semiconductor layer 22 is a low-concentration epitaxial layer (p-) formed by epitaxial growth.

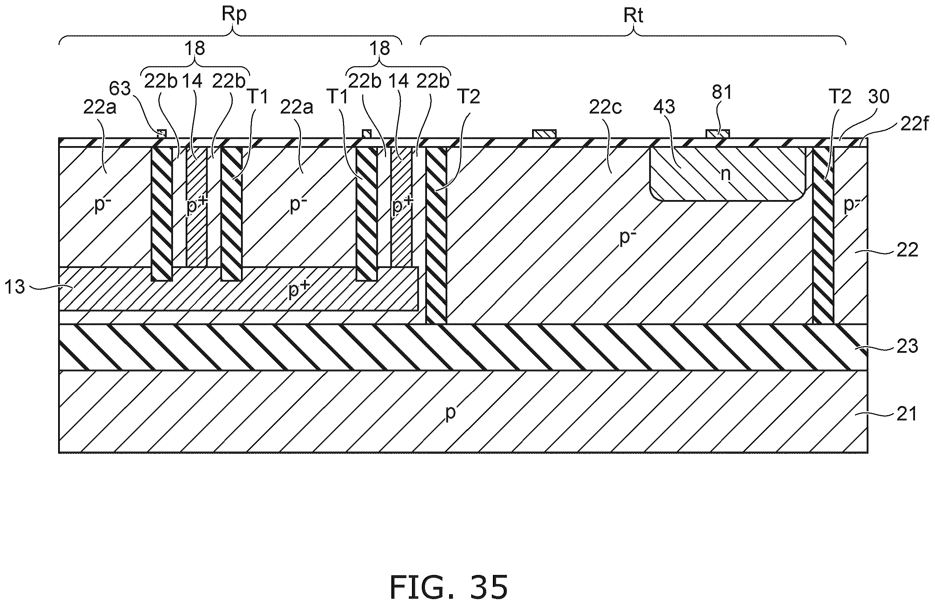

Then, as illustrated in FIG. 35, a deep rectangular trench T1 is formed with a high aspect ratio in the second semiconductor layer 22 by using reactive ion etching, etc. The trench T1 is the element separation structure of the light-receiving element 10 and performs the role of separating the adjacent light-receiving elements 10 and the peripheral region. The bottom portion of the trench T1 does not extend to the insulating layer 23 and stops inside the second semiconductor layer 22. Similarly, the deep rectangular trench T2 is formed with a high aspect ratio in the second semiconductor layer 22 by using reactive ion etching, etc. The trench T2 is the element separation structure of the transistor region Rt and electrically isolates the transistor region Rt from the light-receiving region Rp by extending to the insulating layer 23. Subsequently, the interiors of the trenches T1 and T2 are filled with an insulating material by performing sidewall oxidation by heat treatment, filling an insulating film such as an oxide film, etc. Subsequently, the third semiconductor region 13 is formed as a p⁺-semiconductor layer by implanting a p-type impurity such as boron or the like into the lower region of the light-receiving element 10 with conditions of a MeV-order high acceleration voltage and high concentration. Then, for example, the fourth semiconductor region 14 (p⁺) that has a lattice-shaped pattern between the trenches is formed by implanting a p-type impurity with a high concentration into the second semiconductor layer 22b in the region outside the rectangular trench T1 (the seam area between the light-receiving elements). That is, the region outside the trench T1 of the light-receiving element 10 is used to form the bias region 18 that includes the second semiconductor layer 22b and the fourth semiconductor region 14 formed by impurity implantation into the second semiconductor layer 22b. A PMOS n-well (a well region 43) is formed by implanting an n-type impurity such as phosphorus or the like into the second semiconductor layer 22c in the region inside the trenches T2 located in the transistor region Rt. Subsequently, the insulating layer 30 such as a thermal oxide film or the like is deposited on the upper surface 22f of the second semiconductor layer 22 by heat treatment, etc. The quenching part 63 that has a high resistance is formed in the light-receiving region Rp on the deposited insulating layer 30 by, for example, depositing polysilicon doped with an impurity and patterning the polysilicon. In the transistor region Rt, the gate electrode 81 is formed by depositing, patterning, and saliciding polysilicon.

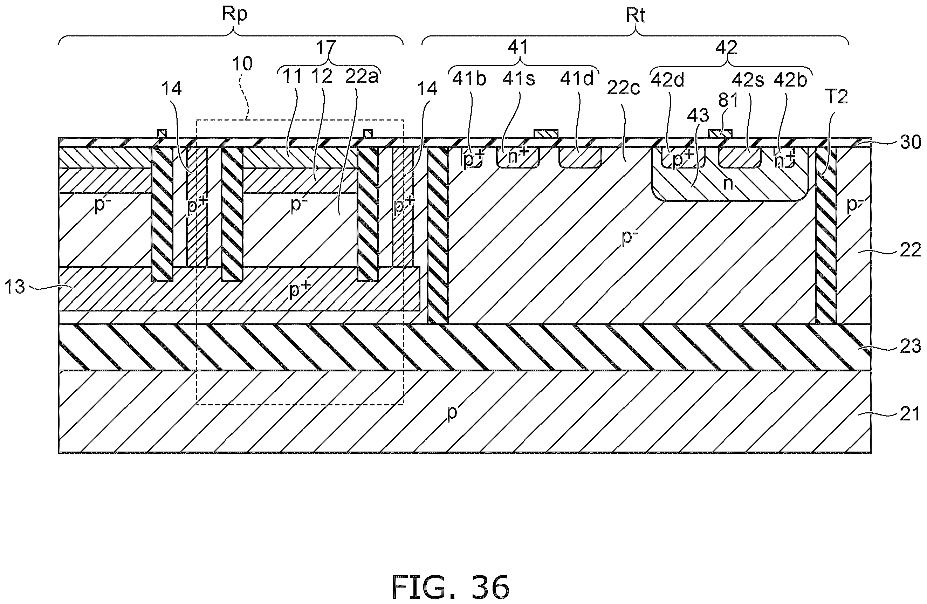

Continuing as illustrated in FIG. 36, in the region (the second semiconductor layer 22a) of the light-receiving element surrounded with the rectangular trench T1, the second semiconductor region 12 is formed by implanting a p-type impurity; and the first semiconductor region 11 is formed by implanting an n-type impurity. At this time, the second semiconductor layer 22a inside the trench T1 of the light-receiving element 10 forms a n⁺/p/p⁻/p⁺ reach-through photodiode from the front side. In the transistor region Rt, the NMOS 41 and the PMOS 42 are formed by implanting a p-type impurity and an n-type impurity with a high concentration into the second semiconductor layer 22c and the well region 43 for forming the PMOS. The NMOS 41 includes an n-type impurity implanted into a source region 41s and a drain region 41d and a p-type impurity implanted into a substrate bias region 41b. The PMOS 42 includes a p-type impurity implanted into a source region 42s and a drain region 42d and an n-type impurity implanted into a well bias region 42b.

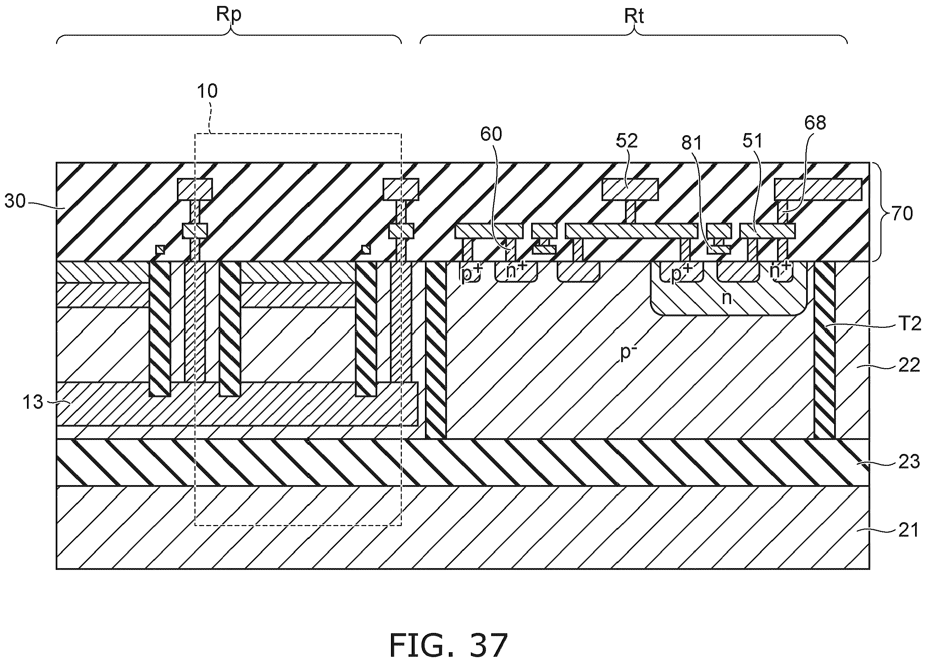

Then, as illustrated in FIG. 37, several layers are made by repeatedly performing the deposition and planarization of the insulating layer 30, the formation of holes (e.g., the contact holes 60) for conduction, and the formation and patterning of metal films. Specifically, after forming the quenching part 63, the insulating layer 30 is deposited, and planarization is performed by, for example, CMP (Chemical Mechanical Polishing), etc. Subsequently, the contact holes 60 are formed on the first semiconductor region 11, i.e., the photodiode part of the light-receiving element 10, on the quenching part 63, and on the fourth semiconductor region 14 and are filled with, for example, a conductive material such as tungsten, etc. Then, the first wiring layer 51, i.e., a metal film of, for example, Al, Cu, or the like is formed and patterned. Then, similar processes are used to pattern the interlayer interconnects 68 and the second wiring layer 52, and while not illustrated in the drawings, the quenching part 63 is connected in series via the first wiring layer 51 and the contact holes 60 from the first semiconductor region 11; and the other end of the quenching part 63 is connected to the first wiring layer 51 via the contact hole 60. The first wiring layers 51 of the light-receiving elements 10 are connected in parallel and connected to the integrated circuit located in the transistor region Rt via the interlayer interconnects 68 and the second wiring layer 52 as necessary. Simultaneously, a contact hole 60 is formed on the fourth semiconductor region 14 and connected similarly to the integrated circuit of the transistor region Rt via the first wiring layer 51, and as necessary, via the interlayer interconnects 68 and the second wiring layer 52. In the transistor region Rt, the contact holes 60 are formed respectively at the source regions of (41s and 42), the drain regions (41d and 42d), and the gate electrodes 81 of the NMOS 41 and the PMOS 42, the well bias region 42b, and the substrate bias region 41b, and are filled with, for example, a conductive material such as tungsten, etc. Then, the first wiring layer 51, i.e., a metal film of, for example, Al, Cu, or the like is formed and patterned. Then, by similar processes, the interlayer interconnect 68 and the second wiring layer 52 are patterned, a CMOS logic IC is configured, and the desired integrated circuit is realized by the wiring combination.

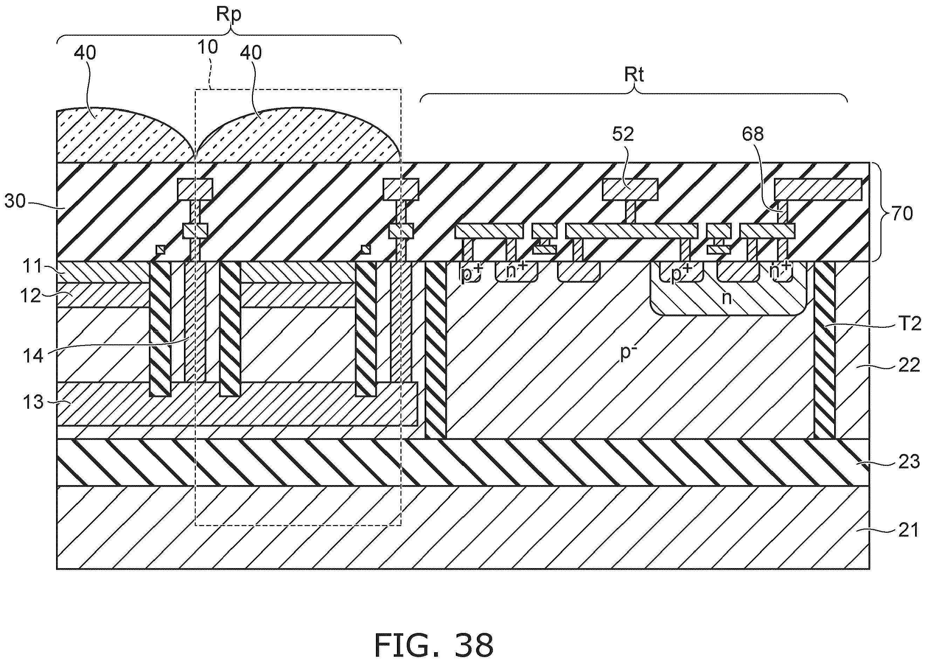

Continuing, although not illustrated in FIG. 38, the upper surface metal portion of the electrode pad is exposed by removing the insulating layer 30 above the electrode pad of the second wiring layer 52. Subsequently, for example, the light concentrator 40 such as, for example, a microlens is formed above the light-receiving element 10 as illustrated in FIG. 38 by coating a photosensitive resist, exposing and developing into a desired mask pattern, and by performing reflow processing.

Thus, the light detector described according to the manufacturing method of the embodiment can be manufactured using only general semiconductor processes using an SOI substrate, and can be realized without the need of a special post process, etc. For example, when modifying necessary characteristics or the wavelength of the light to be detected, characteristic improvement and optimization adjustments are possible by modifying only the specifications of the SOI substrate; and there are expectations for improving the development speed compared to a conventional impurity profile modification. In the case of a general silicon substrate, there is a risk of some effects in the transistor region because a potential is applied from the back surface of the silicon substrate and conducts in the transistor region as well. Particularly when a large quantity of charge is generated in the light-receiving element and a large current flows, there is a possibility that an unintended unexpected error such as latchup, etc., may occur. On the other hand, the light detector of the embodiment has a structure in which the trench that surrounds the transistor region extends to the BOX layer and provides complete separation from the light-receiving region, resulting in no effects on the transistor characteristics due to carrier inflow from the light-receiving region, etc.; therefore, a guaranteed mass production process can be used as-is, and efforts can be focused on only developing the light-receiving element characteristics. Lower costs are expected because the mass production line can accommodate many product lines by performing only a substrate specification modification. As a secondary effect of the characteristics of the light detector, in the case of a general silicon substrate, the carriers due to photoelectric conversion in a deep region diffuse and generate an output signal that lags behind the output signal caused by the other carriers. This causes, for example, a crucial error signal in a LiDAR system based on the TOF (Time Of Flight) principle. On the other hand, in the light detector of the embodiment, the carriers that are generated by photoelectric conversion at the support substrate in the deep region are insulated from the photoelectric conversion part by the void or the BOX layer and therefore do not generate an output signal. In other words, the detector of the embodiment not only improves the sensitivity but also drastically improves the S/N by removing output signals that form an error component of the detected output signal. The structures and the manufacturing method of the embodiment described above are merely examples of the embodiment, and are not limited to these examples as there are structures and/or processes not illustrated in the drawings and descriptions. In particular, it is sufficient for the trench formed in the transistor region to be able to electrically block the effects on the transistor of transient phenomena of the light-receiving element; and the shape, length, arrangement pattern, and the like of the trench are not limited.

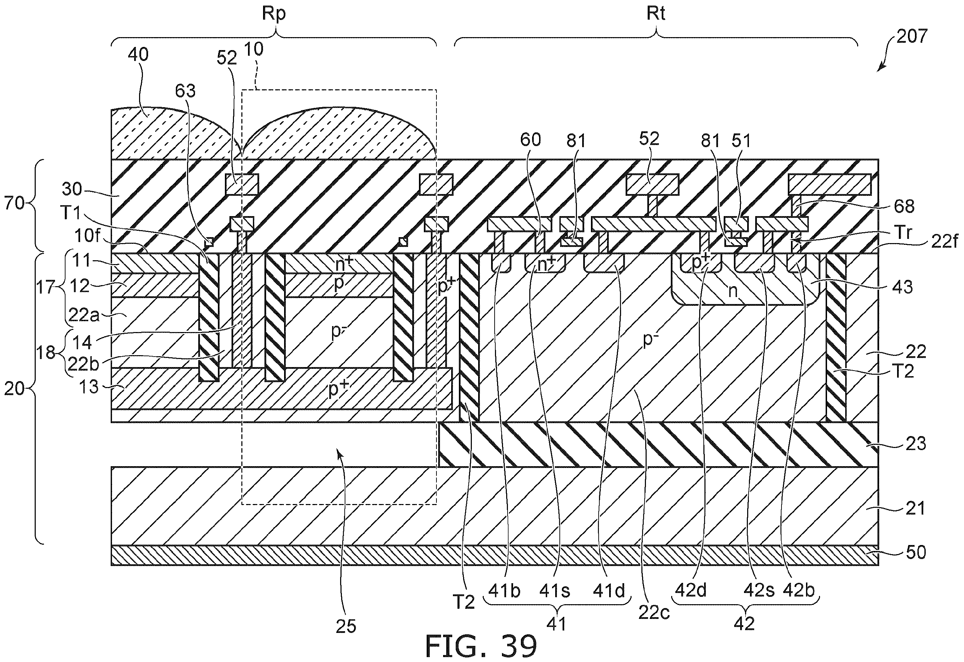

FIG. 39 is a schematic cross-sectional view illustrating a light detector according to the second embodiment.

The light detector 207 illustrated in FIG. 39 differs from the light detector 202 illustrated in FIG. 29 in that a conductive layer 50 is further included. The conductive layer 50 is, for example, a back electrode. The first semiconductor layer 21 is located on the conductive layer 50. The first semiconductor layer 21 contacts the conductive layer 50 and is electrically connected with the conductive layer 50. The conductive layer 50 includes, for example, at least one metal selected from the group consisting of titanium, tungsten, copper, gold, silver, nickel, aluminum, indium, and tin.

The void 25 is provided between the photoelectric conversion part 17 and a portion of the conductive layer 50. By providing the void 25 under the photoelectric conversion part 17, for example, the light that travels downward can be reflected upward at the interface between the second semiconductor layer 22 and the void 25 and at the interface between the void 25 and the first semiconductor layer 21. Also, by providing the void 25, the relative dielectric constant between the first semiconductor layer 21 and the second semiconductor layer 22 can be different between the transistor region Rt and the light-receiving region Rp that includes the light-receiving element 10. Specifically, the transistor region Rt has a higher dielectric constant than the light-receiving region Rp.

Accordingly, by providing such a conductive layer 50, a voltage can be selectively applied to only the transistor region Rt. For example, the operations of the NMOS 41 and the PMOS 42 (e.g., the threshold voltages, etc.) can be controlled while suppressing interference between the light-receiving region Rp and the transistor region Rt.

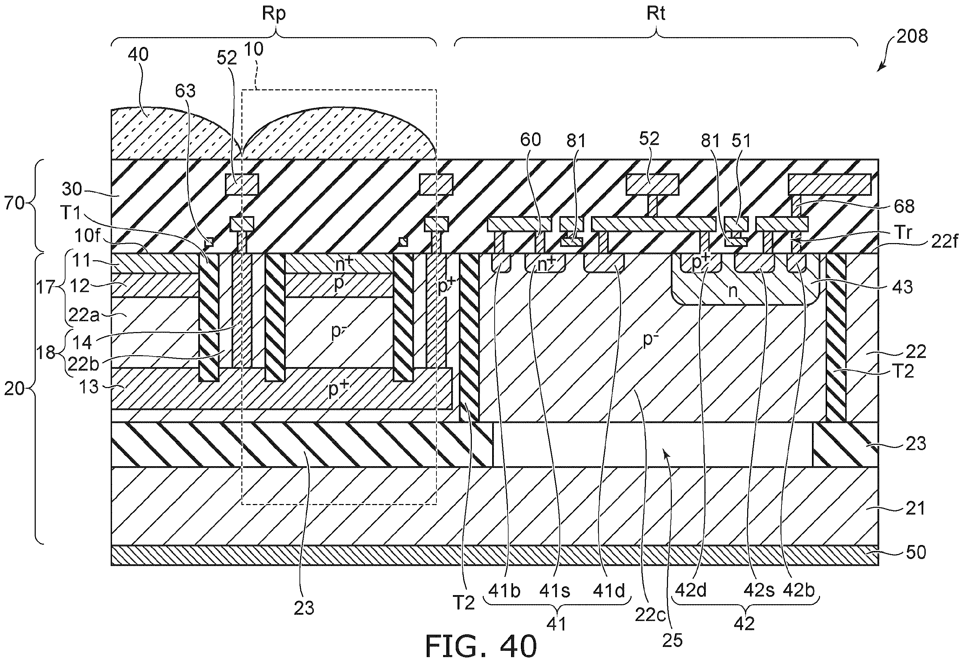

FIG. 40 is a schematic cross-sectional view illustrating a light detector according to the second embodiment.

The shapes of the insulating layer 23 and the void 25 of the light detector 208 illustrated in FIG. 40 are different from those of the light detector 207 illustrated in FIG. 39. Namely, the transistor region Rt is located on the void 25. The insulating layer 23 is located below the light-receiving region Rp.

The void 25 is provided between the conductive layer 50 and the transistor region Rt (the NMOS 41 and the PMOS 42). By providing the void 25, the relative dielectric constant between the first semiconductor layer 21 and the second semiconductor layer 22 can be different between the transistor region Rt and the light-receiving region Rp that includes the light-receiving element 10. Specifically, the light-receiving region Rp has a higher dielectric constant than the transistor region Rt.

Accordingly, by providing such a conductive layer 50, a voltage can be selectively applied to only the light-receiving region Rp. For example, the drive voltage of the photoelectric conversion part 17 can be controlled while suppressing interference between the light-receiving region Rp and the transistor region Rt.

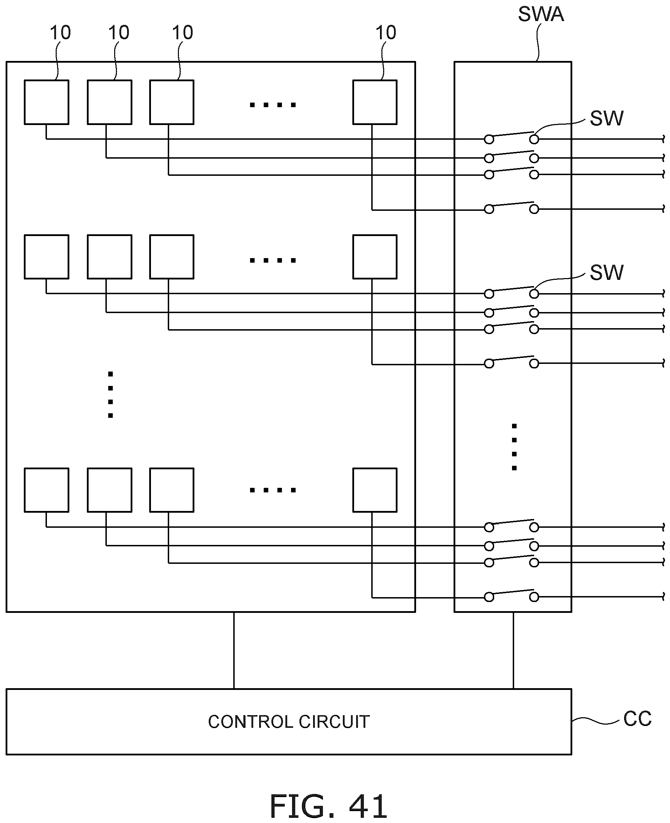

FIG. 41 is a schematic view illustrating an active quenching circuit.

In the light detector according to the embodiments described above, a resistor that generates a large voltage drop is included as the quenching part 63. In the light detector according to embodiments, a control circuit and a switching element may be included instead of the resistor. In other words, an active quenching circuit for blocking the current is included as the quenching part 63.

As shown in FIG. 41, the active quenching circuit includes a control circuit CC and a switching array SWA. The control circuit CC includes a comparator, a control logic part, etc. The switching array SWA includes multiple switching elements SW. For example, at least a portion of the circuit elements included in the control circuit CC and the switching elements SW is located in the second semiconductor layer 22. In other words, the active quenching circuit that is provided as the photoelectric conversion part 17 and the quenching part 63 is provided in the same substrate, and more specifically, in the same semiconductor layer 22. A portion of the active quenching circuit may be located on the first semiconductor layer 21 or may be located on a circuit board other than the first semiconductor layer 21.

As shown in FIG. 41, one switching element SW may be provided for one light-receiving element 10 (photoelectric conversion part), or one switching element SW may be provided for multiple light-receiving elements 10. For example, one switching element SW is located between one first semiconductor region 11 and the first wiring layer 51. Or, the switching element SW may be included in the first wiring layer 51. For example, the switching element SW may be located between the first wiring layer 51 and the first electrode pad 55.

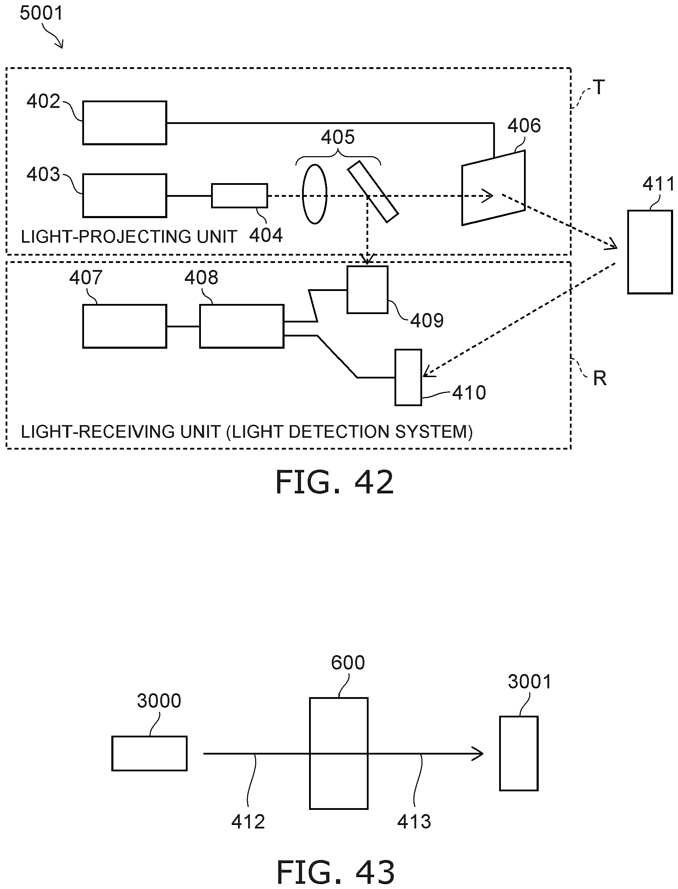

FIG. 42 is a schematic view illustrating a lidar (Light Detection and Ranging (LiDAR)) device according to the embodiment.

The embodiment is applicable to a long-distance subject detection system (LIDAR) or the like that includes a line light source and a lens. The lidar device 5001 includes a light-projecting unit T projecting laser light toward an object 411, and a light-receiving unit R (also called a light detection system) receiving the laser light from the object 411, measuring the time of the round trip of the laser light to and from the object 411, and converting the time into a distance.

In the light-projecting unit T, a light source 404 emits light. For example, the light source 404 includes a laser light oscillator and produces laser light. A drive circuit 403 drives the laser light oscillator. An optical system 405 extracts a portion of the laser light as reference light, and irradiates the rest of the laser light on the object 411 via a mirror 406. A mirror controller 402 projects the laser light onto the object 411 by controlling the mirror 406. Herein, "project" means to cause the light to strike.

In the light-receiving unit R, a reference light detector 409 detects the reference light extracted by the optical system 405. A light detector 410 receives the reflected light from the object 411. A distance measuring circuit 408 measures the distance to the object 411 based on the reference light detected by the reference light detector 409 and the reflected light detected by the light detector 410. An image recognition system 407 recognizes the object 411 based on the measurement results of the distance measuring circuit 408.

The lidar device 5001 employs light time-of-flight ranging (Time of Flight) in which the time of the round trip of the laser light to and from the object 411 is measured and converted into a distance. The lidar device 5001 is applied to an automotive drive-assist system, remote sensing, etc. Good sensitivity is obtained particularly in the near-infrared region when the light detectors of the embodiments described above are used as the light detector 410. Therefore, the lidar device 5001 is applicable to a light source of a wavelength band that is invisible to humans. For example, the lidar device 5001 can be used for obstacle detection for a mobile body.

FIG. 43 describes the detection of the detection object of the lidar device.

A light source 3000 emits light 412 toward an object 600 that is the detection object. A light detector 3001 detects light 413 that passes through the object 600, is reflected by the object 600, or is diffused by the object 600.

For example, the light detector 3001 can realize highly-sensitive detection when the light detector according to the embodiment described above is used. It is favorable to provide multiple sets of the light detector 410 and the light source 404 and to preset the arrangement relationship in the software (which is replaceable with a circuit). For example, it is favorable for the arrangement relationship of the sets of the light detector 410 and the light source 404 to have uniform spacing. Thereby, an accurate three-dimensional image can be generated by the output signals of each light detector 410 complementing each other.

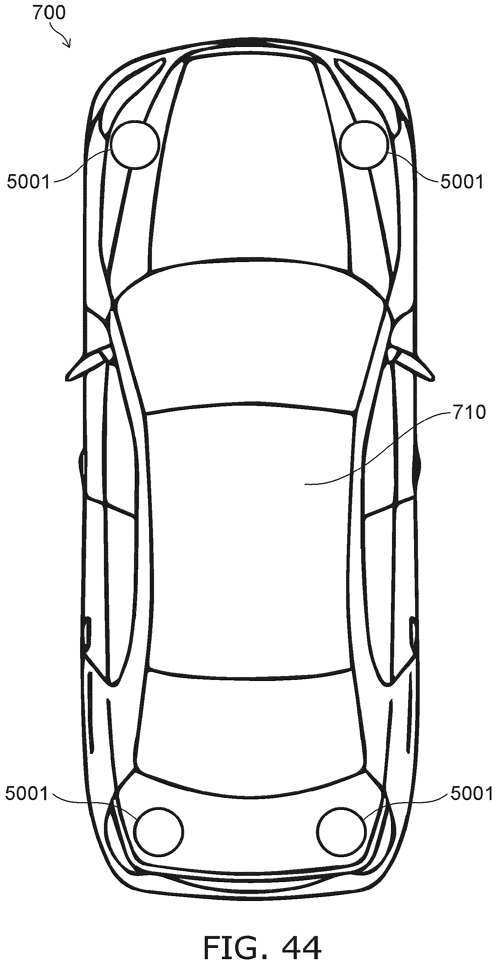

FIG. 44 is a schematic top view of a mobile body that includes the lidar device according to the embodiment.

In the example of FIG. 44, the mobile body is a vehicle. The vehicle 700 according to the embodiment includes the lidar devices 5001 at four corners of a vehicle body 710. Because the vehicle according to the embodiment includes the lidar devices at the four corners of the vehicle body, the environment in all directions of the vehicle can be detected by the lidar devices.

Other than the vehicle illustrated in FIG. 44, the mobile body may be a drone, a robot, etc. The robot is, for example, an automated guided vehicle (AGV). By including the lidar devices at the four corners of the mobile body, the environment in all directions of the mobile body can be detected by the lidar devices.

According to embodiments, a light detector, a light detection system, a lidar device, and a mobile body can be provided in which the sensitivity can be increased.

In the specification of the application, "perpendicular" refers to not only strictly perpendicular but also include, for example, the fluctuation due to manufacturing processes, etc. It is sufficient to be substantially perpendicular.

In this specification, being "electrically connected" includes not only the case of being connected in direct contact, but also the case of being connected via another conductive member, etc.

Embodiments may include the following configurations.

### Configuration 1

A light detector, comprising:
a substrate including
   a first semiconductor layer,
   an insulating layer located on the first semiconductor layer, and
   a second semiconductor layer located on the insulating layer,
the second semiconductor layer including a photoelectric conversion part,
the photoelectric conversion part including
   a first semiconductor region of a first conductivity type, and
   a second semiconductor region of a second conductivity type,
the substrate including
   a void positioned below the photoelectric conversion part and between the first semiconductor layer and the second semiconductor layer, and
   a trench surrounding the photoelectric conversion part, a lower end of the trench being positioned in the second semiconductor layer,
the photoelectric conversion part being electrically connected with a wiring layer at an upper surface side of the substrate via a portion below the trench.

### Configuration 2

The detector according to Configuration 1, wherein
the void extends through the insulating layer.

### Configuration 3

The detector according to Configuration 1 or 2, wherein
a portion of the insulating layer is located between the first semiconductor layer and the photoelectric conversion part, and
the void is located between the photoelectric conversion part and the portion of the insulating layer.

### Configuration 4

The detector according to Configuration 3, wherein
the photoelectric conversion part is positioned above a recess provided in an upper portion of the first semiconductor layer.

### Configuration 5

The detector according to Configuration 3 or 4, wherein
the photoelectric conversion part is positioned above a recess provided in an upper portion of the insulating layer.

### Configuration 6

The detector according to Configuration 1 or 2, wherein
the void is positioned between the first semiconductor layer and the photoelectric conversion part, and
a portion of the insulating layer is located between the void and the photoelectric conversion part.

### Configuration 7

The detector according to Configuration 6, wherein
the photoelectric conversion part is positioned above a recess provided in an upper portion of the first semiconductor layer.

### Configuration 8

The detector according to Configuration 6 or 7, wherein
the photoelectric conversion part is positioned above a recess provided in a lower portion of the insulating layer.

### Configuration 9

The detector according to any one of Configurations 1 to 8, wherein
a plurality of the photoelectric conversion parts is provided, and
the plurality of photoelectric conversion parts is located above one of the voids.

### Configuration 10

The detector according to any one of Configurations 1 to 8, wherein
a plurality of the photoelectric conversion parts is provided,
a plurality of the voids is provided, and
the plurality of photoelectric conversion parts is positioned respectively above the plurality of voids.

### Configuration 11

The detector according to any one of Configurations 1 to 10, wherein
the second semiconductor layer further includes:
   a third semiconductor region positioned above the insulating layer, the third semiconductor region being of the second conductivity type; and
   a fourth semiconductor region positioned above the third semiconductor region, the fourth semiconductor region being of the second conductivity type and being electrically connected with the third semiconductor region,
the trench is positioned between the fourth semiconductor region and the photoelectric conversion part,
a portion of the third semiconductor region is positioned below the trench, and
the third semiconductor region electrically connects the fourth semiconductor region and the photoelectric conversion part.

### Configuration 12

The detector according to Configuration 11, wherein
a plurality of the photoelectric conversion parts is provided,
the plurality of photoelectric conversion parts includes mutually-adjacent photoelectric conversion parts, and
the fourth semiconductor region surrounds the mutually-adjacent photoelectric conversion parts.

### Configuration 13

The detector according to Configuration 11, wherein
the fourth semiconductor region does not surround the photoelectric conversion part.

### Configuration 14

The detector according to Configuration 11 or 13, wherein
the fourth semiconductor region is surrounded with a trench.

### Configuration 15

The detector according to any one of Configurations 1 to 14, further comprising:
a conductive part located inside the trench,
the second semiconductor layer further including a third semiconductor region of the second conductivity type positioned above the insulating layer,
a portion of the third semiconductor region being positioned under a lower end of the conductive part and electrically connecting the conductive part and the photoelectric conversion part.

### Configuration 16

A light detector, comprising:
a substrate including
   a first semiconductor layer,
   an insulating layer located on the first semiconductor layer, and
   a second semiconductor layer located on the insulating layer,
the substrate including
   a light-receiving region including a photoelectric conversion part, the photoelectric conversion part including a first semiconductor region and a second semiconductor region, the first semiconductor region being of a first conductivity type, the second semiconductor region being of a second conductivity type, a first trench being provided in the light-receiving region, and
   a transistor region arranged with the light-receiving region in a direction perpendicular to a first direction, the first direction being from the first semiconductor layer toward the second semiconductor layer, the transistor region including a transistor,
the transistor region including a second trench located between the light-receiving region and at least a portion of the transistor,

in the light-receiving region, the second semiconductor layer further including
a third semiconductor region positioned above the insulating layer, the third semiconductor region being of the second conductivity type, and
a fourth semiconductor region positioned above the third semiconductor region and electrically connected with the third semiconductor region, the fourth semiconductor region being of the second conductivity type,

the first trench being positioned between the fourth semiconductor region and the photoelectric conversion part,
a portion of the third semiconductor region being positioned below the first trench,
the third semiconductor region electrically connecting the photoelectric conversion part and the fourth semiconductor region.

### Configuration 17

The detector according to Configuration 16, wherein
a lower end of the second trench reaches the insulating layer.

### Configuration 18

The detector according to Configuration 16 or 17, wherein
a conductive part is located inside at least a portion of the first or second trench.

### Configuration 19

The detector according to any one of Configurations 16 to 18, wherein
the substrate includes a void positioned between the photoelectric conversion part and a portion of the first semiconductor layer.

### Configuration 20

The detector according to any one of Configurations 16 to 19, wherein
the substrate includes a void positioned between the transistor and a portion of the first semiconductor layer.

### Configuration 21

The detector according to Configuration 19 or 20, wherein
the void extends through the insulating layer.

### Configuration 22

The detector according to Configuration 19, wherein
a portion of the insulating layer is located between the first semiconductor layer and the photoelectric conversion part, and
the void is located between the photoelectric conversion part and the portion of the insulating layer.

### Configuration 23

The detector according to Configuration 22, wherein
the photoelectric conversion part is positioned above a recess provided in an upper portion of the first semiconductor layer.

### Configuration 24

The detector according to Configuration 22 or 23, wherein
the photoelectric conversion part is positioned above a recess provided in an upper portion of the insulating layer.

### Configuration 25

The detector according to Configuration 19, wherein
the void is positioned between the first semiconductor layer and the photoelectric conversion part, and
a portion of the insulating layer is located between the void and the photoelectric conversion part.

### Configuration 26

The detector according to Configuration 25, wherein
the photoelectric conversion part is positioned above a recess provided in an upper portion of the first semiconductor layer.

### Configuration 27

The detector according to Configuration 25 or 26, wherein
the photoelectric conversion part is positioned above a recess provided in a lower portion of the insulating layer.

### Configuration 28

The detector according to any one of Configurations 19 and 22 to 27, wherein
a plurality of the photoelectric conversion parts is provided, and
the plurality of photoelectric conversion parts is located above one of the voids.

### Configuration 29

The detector according to any one of Configurations19 and 22 to 27, wherein
a plurality of the photoelectric conversion parts is provided,
a plurality of the voids is provided, and
the plurality of photoelectric conversion parts is positioned respectively above the plurality of voids.

### Configuration 30

The detector according to any one of Configurations 16 to 29, wherein
a plurality of the photoelectric conversion parts is provided, the plurality of photoelectric conversion parts includes mutually-adjacent photoelectric conversion parts, and
the fourth semiconductor region surrounds the mutually-adjacent photoelectric conversion parts.

### Configuration 31

The detector according to any one of Configurations 16 to 29, wherein
the fourth semiconductor region does not surround the photoelectric conversion part.

### Configuration 32

The detector according to any one of Configurations 16 to 29 and 31, wherein
the fourth semiconductor region is surrounded with a trench.

### Configuration 33

The detector according to any one of Configurations 16 to 32, further comprising:
a conductive part located inside the trench,
a portion of the third semiconductor region being positioned under a lower end of the conductive part and electrically connecting the conductive part and the photoelectric conversion part,
the photoelectric conversion part being electrically connected with a wiring layer at an upper surface side of the substrate via the third semiconductor region and the conductive part.

### Configuration 34

The detector according to any one of Configurations 16 to 32, wherein the photoelectric conversion part being electrically connected with a wiring layer at an upper surface side of the substrate via the third semiconductor region and the fourth semiconductor region.

### Configuration 35

The detector according to any one of Configurations 16 to 34, further comprising:
a conductive layer,
the first semiconductor layer being located between the conductive layer and the insulating layer.

### Configuration 36

The detector according to any one of Configurations 1 to 35, wherein
the photoelectric conversion part is a p-i-n diode or an avalanche photodiode.

### Configuration 37

The detector according to Configuration 36, wherein
the avalanche photodiode operates in a Geiger mode. Configuration 38

A light detection system, comprising:
the detector according to any one of Configurations 1 to 37; and
a distance measuring circuit calculating a time-of-flight of light based on an output signal of the detector.

### Configuration 39

A lidar device, comprising:
a light source irradiating light on an object; and
the light detection system according to Configuration 38,
the light detection system detecting light reflected by the object.

Hereinabove, exemplary embodiments of the invention are described with reference to specific examples. However, the embodiments of the invention are not limited to these specific examples. For example, one skilled in the art may similarly practice the invention by appropriately selecting specific configurations of components included in light detectors such as semiconductor layers, insulating layers, etc., from known art. Such practice is included in the scope of the invention to the extent that similar effects thereto are obtained.

Further, any two or more components of the specific examples may be combined within the extent of technical feasibility and are included in the scope of the invention to the extent that the purport of the invention is included.

Moreover, all light detectors, light detection systems, lidar devices and mobile bodies practicable by an appropriate design modification by one skilled in the art based on the light detectors, the light detection systems, the lidar devices and the mobile bodies described above as embodiments of the invention also are within the scope of the invention to the extent that the purport of the invention is included.

Various other variations and modifications can be conceived by those skilled in the art within the spirit of the invention, and it is understood that such variations and modifications are also encompassed within the scope of the invention.

While certain embodiments have been described, these embodiments have been presented by way of example only, and are not intended to limit the scope of the inventions. Indeed, the novel embodiments described herein may be embodied in a variety of other forms; furthermore, various omissions, substitutions and changes in the form of the embodiments described herein may be made without departing from the spirit of the inventions. The accompanying claims and their equivalents are intended to cover such forms or modifications as would fall within the scope and spirit of the invention.

## Claims

1. A light detector (201), comprising:
a substrate (20) including
a first semiconductor layer (21),
an insulating layer (23) located on the first semiconductor layer (21), and
a second semiconductor layer (22) located on the insulating layer (23),
the substrate (20) including
a light-receiving region (Rp) including a photoelectric conversion part (17), the photoelectric conversion part (17) including a first semiconductor region (11) and a second semiconductor region (12), the first semiconductor region (11) being of a first conductivity type, the second semiconductor region (12) being of a second conductivity type, a first trench (T1) being provided in the light-receiving region (Rp), and
a transistor region (Rt) arranged with the light-receiving region (Rp) in a direction perpendicular to a first direction, the first direction being from the first semiconductor layer (21) toward the second semiconductor layer (22), the transistor region (Rt) including a transistor,
the transistor region (Rt) including a second trench (T2) located between the light-receiving region (Rp) and at least a portion of the transistor,
in the light-receiving region (Rp), the second semiconductor layer (22) further including
a third semiconductor region (13) positioned above the insulating layer (23), the third semiconductor region (13) being of the second conductivity type, and
a fourth semiconductor region (14) positioned above the third semiconductor region (13) and electrically connected with the third semiconductor region (13), the fourth semiconductor region (14) being of the second conductivity type,
the first trench (T1) being positioned between the fourth semiconductor region (14) and the photoelectric conversion part (17),
a portion of the third semiconductor region (13) being positioned below the first trench (T1),
the third semiconductor region (13) electrically connecting the photoelectric conversion part (17) and the fourth semiconductor region (14).

2. The detector (201) according to claim 1, wherein
a lower end of the second trench (T2) reaches the insulating layer (23).

3. The detector (204) according to claim 1 or 2, wherein
a conductive part (75) is located inside at least a portion of the first or second trench (T1, T2).

4. The detector (202) according to any one of claims 1 to 3, wherein
the substrate (20) includes a void (25) positioned between the photoelectric conversion part (17) and a portion of the first semiconductor layer (21).

5. The detector (206) according to any one of claims 1 to 4, wherein
the substrate (20) includes a void (25) positioned between the transistor and a portion of the first semiconductor layer (21).

6. The detector (202) according to claim 4 or 5, wherein
the void (25) extends through the insulating layer (23).

7. The detector according to claim 4, wherein
a portion of the insulating layer (23) is located between the first semiconductor layer (21) and the photoelectric conversion part (17), and
the void (25) is located between the photoelectric conversion part (17) and the portion of the insulating layer (23).

8. The detector according to claim 4, wherein
the void (25) is positioned between the first semiconductor layer (21) and the photoelectric conversion part (17), and
a portion of the insulating layer (23) is located between the void (25) and the photoelectric conversion part (17).

9. The detector (202) according to any one of claims 4, 7 and 8, wherein
a plurality of the photoelectric conversion parts (17) is provided, and
the plurality of photoelectric conversion parts is located above one of the voids (25).

10. The detector (204) according to any one of claims 1 to 9, further comprising:
a conductive part (75) located inside the trench,
a portion of the third semiconductor region (13) being positioned under a lower end of the conductive part (75) and electrically connecting the conductive part (75) and the photoelectric conversion part (17).

11. The detector (207) according to any one of claims 1 to 10, further comprising:
a conductive layer (50),
the first semiconductor layer (21) being located between the conductive layer (50) and the insulating layer (23).

12. The detector (201) according to any one of claims 1 to 11, wherein
the photoelectric conversion part (17) is a p-i-n diode or an avalanche photodiode.

13. The detector (201) according to claim 12, wherein
the avalanche photodiode operates in a Geiger mode.

14. A light detection system, comprising:
the detector according to any one of claims 1 to 13; and
a distance measuring circuit (408) calculating a time-of-flight of light based on an output signal of the detector.

15. A lidar device (5001), comprising:
a light source (404) irradiating light on an object; and
the light detection system according to claim 14,
the light detection system detecting light reflected by the object.
